# EUROPEAN PATENT APPLICATION

(11) **EP 4 723 830 A1**
(43) Date of publication of application: **08.04.2026**
(21) Application number: 25185046.7
(22) Date of filing: 24.06.2025
(51) Int. Cl.: H10D 30/01, H10D 30/47, H10D 62/17, H10D 64/00, H10D 62/85, H10D 64/23

(54) **SEMICONDUCTOR DEVICE**

(30) Priority: 02.10.2024 KR 20240134065; 16.10.2024 KR 20240141135
(71) Applicant: Samsung Electronics Co., Ltd., Suwon-si, Gyeonggi-do 16677 (KR)
(72) Inventor: PARK, Junhyuk, Suwon-si (KR); KIM, Jongseob, Suwon-si (KR); YANG, Seong Seok, Suwon-si (KR); OH, Jaejoon, Suwon-si (KR); HWANG, In Jun, Suwon-si (KR)
(74) Representative: Marks & Clerk LLP

(57) **Abstract**

A semiconductor device includes a channel layer, a barrier layer located on the channel layer, a gate electrode layer located on the barrier layer, a gate semiconductor layer between the barrier layer and the gate electrode layer, a source electrode and a drain electrode connected to the channel layer, a field dispersion layer located on the gate electrode layer, connected to the source electrode, and overlapped with the gate electrode layer, and a source wiring layer located on the field dispersion layer, connected to the source electrode, and overlapped with the gate electrode layer, wherein the source wiring layer extends beyond a first end of the gate electrode layer for a first extension length in the second direction, the field dispersion layer extends beyond the first end of the gate electrode layer for a second extension length, and the first extension length is less than the second extension length.

## Description

### BACKGROUND

The present disclosure relates to a semiconductor device.

In modern society, semiconductor devices are closely related to daily life. In particular, the importance of power semiconductor devices used in various fields such as transportation fields such as electric vehicles, railroads, and electric trams, renewable energy systems such as solar power generation and wind power generation, and mobile devices is gradually increasing. Power semiconductor devices are semiconductor devices used to handle high voltage or high current, and perform functions such as power conversion and control in large power systems or high-output electronic devices. Power semiconductor devices have the ability and durability to handle high power, so they can handle large amounts of current and withstand high voltage. For example, power semiconductor devices can handle voltages from hundreds of volts to thousands of volts and currents from tens of amperes to thousands of amperes. Power semiconductor devices can improve the efficiency of electrical energy by minimizing power loss. Additionally, power semiconductor devices can be stably driven even in environments such as high temperatures.

These power semiconductor devices can be classified according to materials of which they are formed, and examples include SiC power semiconductor devices and GaN power semiconductor devices. Power semiconductor devices are manufactured using SiC or GaN instead of existing silicon (Si), and thereby the disadvantage of silicon, which has unstable characteristics at high temperatures, can be compensated for. The SiC power semiconductor devices are resistant to high temperatures and have low power loss, and can be suitable for electric vehicles, renewable energy systems, etc. The GaN power semiconductor devices have relatively high costs, but are efficient in terms of speed and can be suitable for high-speed charging of mobile devices.

### SUMMARY

One aspect of the present disclosure is to provide a semiconductor device that reduces an electric field peak in a channel layer and efficiently distributes an electric field in a channel layer to flatten a profile, while preventing a voltage drop due to wiring resistance as the area of the semiconductor device increases.

A semiconductor device according to one aspect includes a channel layer, a barrier layer located on the channel layer and including a material having an energy band gap different from that of the channel layer, a gate electrode layer located on the barrier layer and extending in a first direction, a gate semiconductor layer between the barrier layer and the gate electrode layer, a source electrode and a drain electrode connected to the channel layer and each spaced apart from the gate electrode layer in a second direction different from the first direction, a field dispersion layer located on the gate electrode layer, connected to the source electrode, and overlapped with the gate electrode layer in a third direction different from the first and second directions, and a source wiring layer located on the field dispersion layer, connected to the source electrode, and overlapped with the gate electrode layer in the third direction, wherein the source wiring layer extends beyond a first end of the gate electrode layer facing away from the source electrode by a first extension length in the second direction, the field dispersion layer extends beyond the first end of the gate electrode layer for a second extension length, and the first extension length is less than the second extension length.

A semiconductor device according to another aspect includes a channel layer, a barrier layer located on the channel layer and including a material having an energy band gap different from that of the channel layer, a gate electrode layer located on the barrier layer and extending in a first direction, a gate semiconductor layer between the barrier layer and the gate electrode layer, a source electrode and a drain electrode connected to the channel layer and each spaced apart from the gate electrode layer in a second direction different from the first direction, a field dispersion layer located on the gate electrode layer, connected to the source electrode, and overlapped with the gate electrode layer in a third direction different from the first and second directions, and a source wiring layer located on the gate electrode layer, connected to the source electrode, and overlapped with the field dispersion layer in the third direction, wherein the source wiring layer extends beyond a first end of the gate electrode layer facing away from the source electrode for a first extension length in the second direction, the field dispersion layer extends beyond the first end of the gate electrode layer for a second extension length, and the first extension length is less than the second extension length.

A semiconductor device according to another aspect includes a channel layer, a barrier layer located on the channel layer and including a material having an energy band gap different from that of the channel layer, a gate electrode layer located on the barrier layer and extending in a first direction, a gate semiconductor layer between the barrier layer and the gate electrode layer, a source electrode and a drain electrode connected to the channel layer and each located spaced apart from the gate electrode layer in a second direction different from the first direction, a field dispersion layer located on the gate electrode layer, connected to the source electrode, and overlapped with the gate electrode layer in a third direction different from the first and second directions, and a source wiring layer located on the field dispersion layer, connected to the source electrode, and overlapped with the gate electrode layer in the third direction, wherein an end of the source wiring layer in the second direction extending away from the source electrode is overlapped with the field dispersion layer in the third direction, the field dispersion layer is located between the source wiring layer and the barrier layer in the third direction, and an end of the field dispersion layer in the second direction is between the end of the source electrode and an end of the barrier layer facing the drain electrode in the second direction.

The semiconductor device according to embodiments can reduce an electric field peak in a channel layer and efficiently distribute an electric field in the channel layer to flatten the profile, while preventing a voltage drop due to wiring resistance as the area of the semiconductor device increases.

At least some of the above and other features of the invention are set out in the claims.

### BRIEF DESCRIPTION OF THE DRAWINGS

FIG. 1 is a plan view showing a semiconductor device according to an embodiment.
FIG. 2 is a plan view showing a semiconductor device according to an embodiment.
FIG. 3 is a plan view showing a semiconductor device according to an embodiment.
FIG. 4 is a plan view showing a semiconductor device according to an embodiment.
FIG. 5 is a cross-sectional view taken along line A-A' of FIG. 4.
FIG. 6 is a cross-sectional view taken along line B-B' of FIG. 4.
FIG. 7 is a cross-sectional view showing another embodiment, corresponding to the view of FIG. 5.
FIG. 8 is a cross-sectional view showing another embodiment, corresponding to view of FIG. 5.
FIG. 9 is a cross-sectional view showing another embodiment, corresponding to the view of FIG. 8.
FIG. 10 is a plan view showing a semiconductor device according to an embodiment.
FIG. 11 is a cross-sectional view taken along line A-A' of FIG. 10.

### DETAILED DESCRIPTION OF THE EMBODIMENTS

Hereinafter, various embodiments will be described in detail with reference to the attached drawings so that a person having ordinary skill in the art to which the present disclosure pertains can implement the inventive concept. The inventive concept may be embodied in many different forms and is not limited to the embodiments set forth herein. It should also be emphasized that the disclosure provides details of alternative examples, but such listing of alternatives is not exhaustive. Furthermore, any consistency of detail between various examples should not be interpreted as requiring such detail.

The drawings and description are to be regarded as illustrative in nature and not restrictive. Like reference numerals designate like elements throughout the specification.

The size and thickness of each constituent element as shown in the drawings are randomly indicated for better understanding and ease of description, and inventive concept is not limited to the embodiments shown in the drawings. In the drawings, the thickness of layers, regions, etc., are exaggerated for clarity. In addition, in the drawings, for better understanding and ease of description, the thickness of some layers and areas is exaggerated.

It will be understood that when an element such as a layer, film, region, or substrate is referred to as being "connected" or "coupled" to or "on" another element, it can be directly connected or coupled to or on the other element or intervening elements may also be present. In contrast, when an element is referred to as being "directly connected" or "directly coupled" or "directly on" another element, or as "contacting" or "in contact with" another element, there are no intervening elements present at the point of contact. The word "on" or "above" means being disposed on or below the object portion, and does not necessarily mean being disposed on the upper side of the object portion based on a gravitational direction.

As used herein, components described as being "electrically connected" are configured such that an electrical signal can be transferred from one component to the other (although such electrical signal may be attenuated in strength as it is transferred and may be selectively transferred). Moreover, components that are "directly electrically connected" form a common electrical node through electrical connections by one or more conductors, such as, for example, wires, pads, internal electrical lines, through vias, etc. As such, directly electrically connected components do not include components electrically connected through active elements, such as transistors or diodes.

In addition, unless explicitly described to the contrary, the word "comprise," and variations such as "comprises" or "comprising," will be understood to imply the inclusion of stated elements but not the exclusion of any other elements.

Throughout the specification, when a component is described as "including" a particular element or group of elements, it is to be understood that the component may be formed of only the element or the group of elements, or the element or group of elements may be combined with additional elements to form the component, unless the context indicates otherwise. The term "consisting of," on the other hand, indicates that a component is formed only of the element(s) listed.

Ordinal numbers such as "first," "second," "third," etc. may be used simply as labels of certain elements, steps, etc., to distinguish such elements, steps, etc. from one another. Terms that are not described using "first," "second," etc., in the specification, may still be referred to as "first" or "second" in a claim. In addition, a term that is referenced with a particular ordinal number (e.g., "first") in a particular claim may be described elsewhere with a different ordinal number (e.g., "second") in the specification or another claim.

Items described in the singular herein may be provided in plural, as can be seen, for example, in the drawings. Thus, the description of a single item that is provided in plural should be understood to be applicable to the remaining plurality of items unless context indicates otherwise.

In addition, in this specification, the phrase "on a plane" means viewing a target portion from the top, and the phrase "on a cross-section" means viewing a cross-section formed by vertically cutting a target portion from the side.

In addition, throughout the specification, two directions parallel to the upper surface of the substrate and intersecting one another are defined as the first direction D1 and the second direction D2, respectively, and a direction perpendicular to the upper surface of the substrate is defined as the third direction D3. For example, the first direction D1 and the second direction D2 may be perpendicular to each other.

As used herein, the terms "formed integrally", "material continuity" and "materially in continuity" may refer to structures, patterns, and/or layers that are formed at the same time and of the same material, without a break in the continuity of the material of which they are formed. As one example, structures, patterns, and/or layers that are "formed integrally", have "material continuity" or are formed "materially in continuity" may be homogeneous monolithic structures.

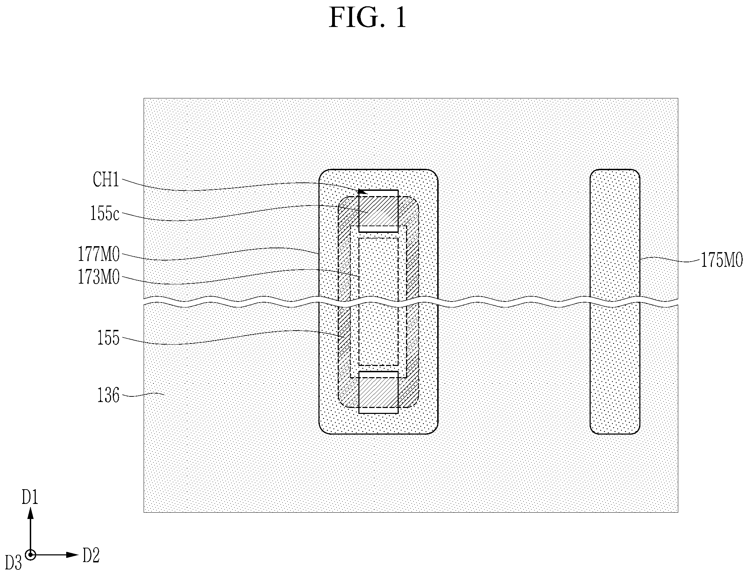

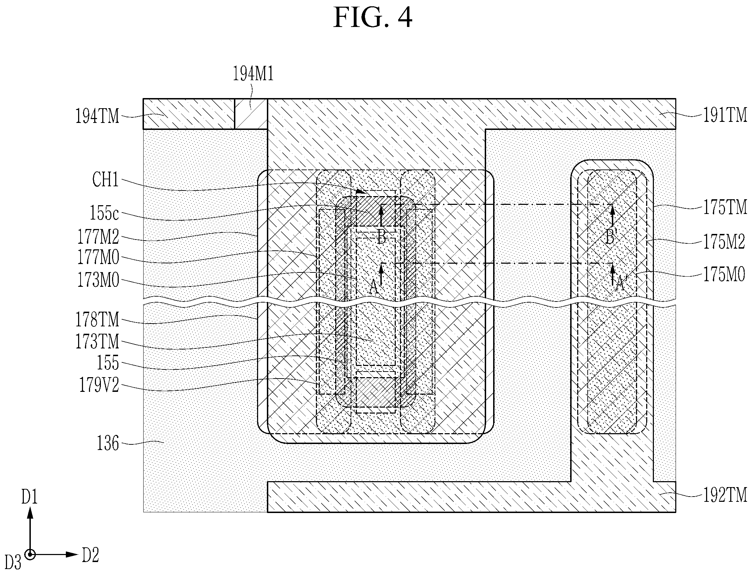

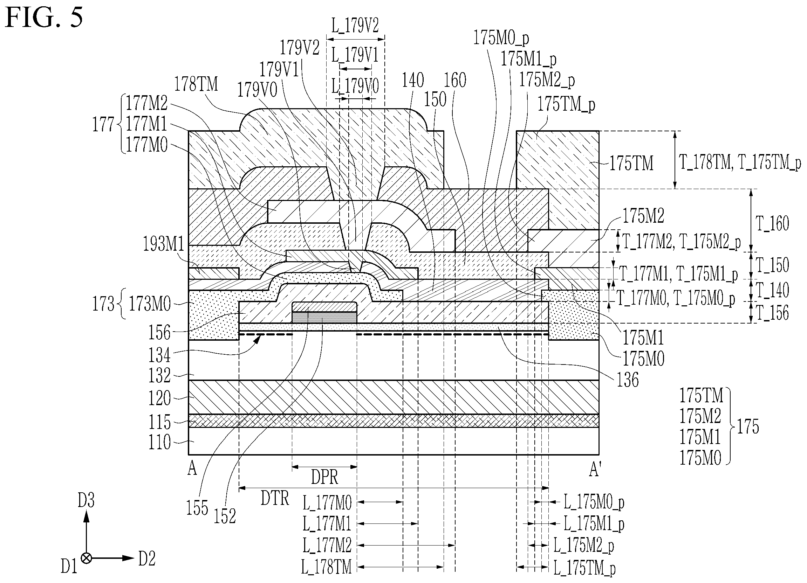

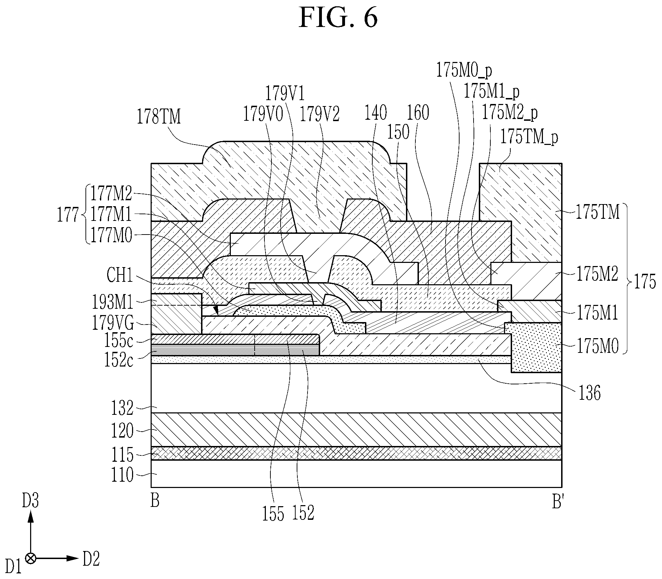

FIGS. 1 to 4 are plan views illustrating a semiconductor device according to embodiments. FIG. 5 is a cross-sectional view taken along line A-A' of FIG. 4. FIG. 6 is a cross-sectional view taken along line B-B' of FIG. 4. As used herein, a semiconductor device may refer to any of the various devices such as shown in figures, and may also refer, for example, to two transistors or a device such as a semiconductor chip, a stack of semiconductor chips, a semiconductor package including one or more semiconductor chips stacked on a package substrate, or a package-on-package device including a plurality of packages.

For a clear understanding and simple illustration, FIG. 1 mainly illustrates a barrier layer 136, a gate electrode layer 155, a first source electrode 173M0, a first drain electrode 175M0, and a first field dispersion layer 177M0, and additionally illustrates a gate connection portion 155c and a gate contact hole CH1. Other elements may be present that may be unrelated to the present description and therefore may be omitted.

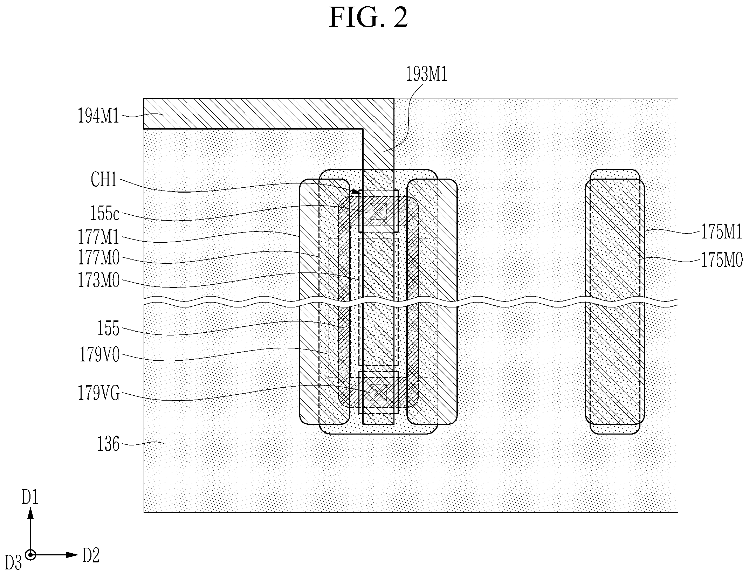

FIG. 2 illustrates a barrier layer 136, a gate electrode layer 155, a first source electrode 173M0, a first drain electrode 175M0, a second drain electrode 175M1, a first field dispersion layer 177M0, and a second field dispersion layer 177M1, and additionally illustrates a gate connection portion 155c, a gate contact hole CH1, a first via 179V0, a gate via 179VG, a gate draw out line 193M1, and a gate signal line 194M1.

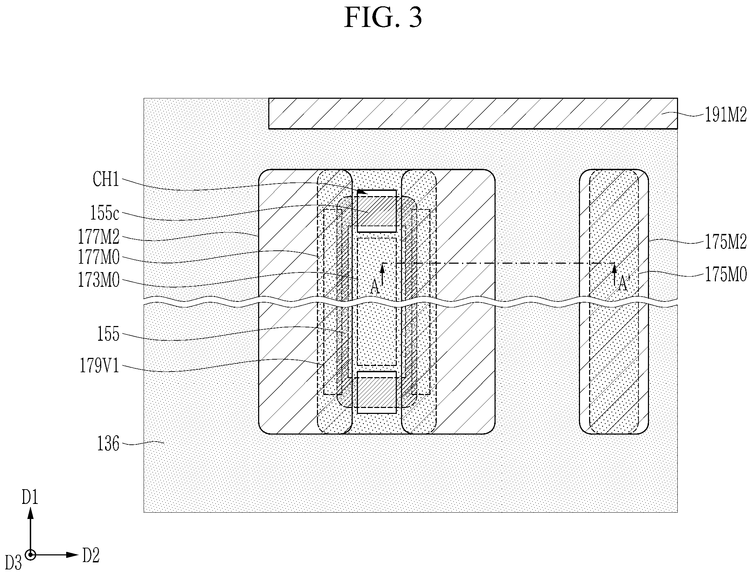

In FIG. 3, a barrier layer 136, a gate electrode layer 155, a first source electrode 173M0, a first drain electrode 175M0, a third drain electrode 175M2, a first field dispersion layer 177M0, and a third field dispersion layer 177M2 are illustrated, and additionally, a gate connection portion 155c, a gate contact hole CH1, a second via 179V1, and a source signal line 191M2 are illustrated, and the illustrations of the second drain electrode 175M1 and the second field dispersion layer 177M1 are omitted.

In FIG. 4, a barrier layer 136, a gate electrode layer 155, a first source electrode 173M0, a fourth source electrode 173TM, a first drain electrode 175M0, a third drain electrode 175M2, a fourth drain electrode 175TM, a first field dispersion layer 177M0, a third field dispersion layer 177M2, and a source wiring layer 178TM are illustrated, and additionally, a gate connection portion 155c, a gate contact hole CH1, a third via 179V2, a gate signal line 194M1, a source pad 191TM, a drain pad 192TM, and a gate pad 194TM are illustrated, and the illustration of the second drain electrode 175M1 and the second field dispersion layer 177M1 is omitted.

Referring to FIGS. 1 to 6, the semiconductor device includes a channel layer 132, a barrier layer 136 on the channel layer 132, a gate electrode layer 155 on the barrier layer 136, a gate semiconductor layer 152 positioned between the barrier layer 136 and the gate electrode layer 155, and a source electrode 173 and a drain electrode 175 located on opposite sides of the gate electrode layer 155 and connected to the channel layer 132.

The channel layer 132 is a layer that forms a channel between the source electrode 173 and the drain electrode 175, and the channel can be modeled as a two-dimensional electron gas (2DEG) 134 located inside the channel layer 132. The two-dimensional electron gas 134 is a charge transport model used in solid-state physics, and refers to a group of electrons that can move freely in two dimensions (e.g., in the x-y plane direction) but cannot move in another dimension (e.g., in the z direction) and are tightly bound within the two dimensions. For example, the two-dimensional electron gas 134 can exist in a two-dimensional paper-like form within a three-dimensional space. This two-dimensional electron gas 134 mainly appears in a semiconductor heterojunction structure, and in a semiconductor device according to an embodiment, it can occur at the interface between the channel layer 132 and the barrier layer 136. For example, a two-dimensional electron gas 134 may be generated in the portion closest to the barrier layer 136 within the channel layer 132.

The channel layer 132 may include nitride including a material from the Group III-V materials, for example, Al, Ga, In, B, or a combination thereof. The channel layer 132 may be made of a single layer or multiple layers. As an example, the channel layer 132 may include AlₓIn_{y}Ga_{1-x-y}N (0≤x≤1, 0≤y≤1, x+y≤1). For example, the channel layer 132 may include AIN, GaN, InN, InGaN, AlGaN, AlInN, AlInGaN, or a combination thereof. The channel layer 132 may be a layer doped with impurities or a layer undoped with impurities. A thickness of the channel layer 132 may be about several hundred nm or less.

The channel layer 132 may be located on the substrate 110, and a seed layer 115, or a buffer layer 120 may be located between the substrate 110 and the channel layer 132. The substrate 110, the seed layer 115, and the buffer layer 120 are layers necessary to form the channel layer 132, and may be omitted in some cases. For example, when a substrate made of GaN is used as the channel layer 132, at least one of the substrate 110, the seed layer 115, and the buffer layer 120 may be omitted. Considering that the price of a substrate made of GaN is relatively high, the channel layer 132 including GaN can be grown using the substrate 110 made of Si. Since the lattice structure of Si and GaN are different, it may be difficult to grow the channel layer 132 directly on the substrate 110. Accordingly, the seed layer 115 and the buffer layer 120 can be first grown on the substrate 110, and then the channel layer 132 can be grown on the buffer layer 120. Additionally, at least one of the substrate 110, the seed layer 115, and the buffer layer 120 may be removed from the final structure of the semiconductor device after being used in the manufacturing process.

The substrate 110 may include a semiconductor material. For example, the substrate 110 may include sapphire, Si, SiC, AIN, GaN, or a combination thereof. The substrate 110 may be a silicon on insulator (SOI) substrate. However, the material of the substrate 110 is not limited to these examples, and any commonly used substrate material can be applied. In some cases, the substrate 110 may include an insulating material. For example, several layers, including the channel layer 132, may be first formed on a semiconductor substrate, then the semiconductor substrate may be removed and replaced with an insulating substrate.

The seed layer 115 may be located on the substrate 110. The seed layer 115 may be located directly on the substrate 110. However, it is not limited to this, and another predetermined layer may be further located between the substrate 110 and the seed layer 115. The seed layer 115 is a layer that serves as a seed for growing the buffer layer 120, and may be made of a crystal lattice structure that serves as a seed for the buffer layer 120. For example, the seed layer 115 may include AlN, but is not limited thereto.

The buffer layer 120 may be located on the seed layer 115. The buffer layer 120 may be located directly on the seed layer 115 (e.g., may contact the seed layer 115). However, it is not limited to this, and another predetermined layer may be further located between the seed layer 115 and the buffer layer 120. The buffer layer 120 may be located between the seed layer 115 and the channel layer 132. The buffer layer 120 may include nitride including a material from the Group III-V materials, for example, Al, Ga, In, B, or a combination thereof. The buffer layer 120 may include AlₓIn_{y}Ga_{1-x-y}N (0≤x≤1, 0≤y≤1, x+y ≤ 1). For example, the buffer layer 120 may include AlN, GaN, InN, InGaN, AlGaN, AllnN, AllnGaN, or a combination thereof. The buffer layer 120 may be made of a single layer or multiple layers. For example, the buffer layer 120 may include a superlattice layer and a high-resistance layer.

The superlattice layer alleviates a difference in lattice constant and thermal expansion coefficient between the substrate 110 and the channel layer 132, thereby relieving tensile stress and compressive stress generated between the substrate 110 and the channel layer 132.

The high-resistance layer may be located on the superlattice layer. For example, the high-resistance layer may be located directly on the superlattice layer. However, the inventive concept is not limited to this example, and other layers may be located between the superlattice layer and the high-resistance layer. The high-resistance layer may be located between the superlattice layer and the channel layer 132. The high-resistance layer can prevent the semiconductor element from deteriorating by preventing leakage current from flowing through the channel layer 132. The high-resistance layer may be made of a low-conductivity material to electrically insulate the substrate 110 and the channel layer 132.

For example, the high-resistance layer can have a resistance value of greater than or equal to about 1.0X10⁶ Ω·cm. For example, the resistance value of the high-resistance layer may be greater than or equal to about 1.0X10¹⁰ Ω·cm. As another example, the resistance value of the high-resistance layer can be greater than or equal to about 1.0X10¹² Ω·cm. Resistance values can be measured by forming a measuring electrode within a high-resistance layer and allowing current to flow.

The high-resistance layer may include a nitride including a material from the Group III-V materials, such as Al, Ga, In, B, or a combination thereof. The high-resistance layer 126 may include AlₓIn_{y}Ga_{1-x-y}N (0≤x≤1, 0≤y≤1, x+y≤1), and may include, for example, AIN, GaN, InN, InGaN, AlGaN, AllnN, AllnGaN, or a combination thereof. The high-resistance layer may be composed of a single layer or multiple layers.

The barrier layer 136 is located on the channel layer 132. The barrier layer 136 may be located directly on the channel layer 132. However, it is not limited to this, and another predetermined layer may be further located between the channel layer 132 and the barrier layer 136. A region of the channel layer 132 that is overlapped with the barrier layer 136 may be a drift region DTR. The drift region DTR may be located between the source electrode 173 and the drain electrode 175. When a potential difference occurs between the source electrode 173 and the drain electrode 175, carriers may move in the drift region DTR. The semiconductor device may be turned on/off depending on whether a voltage is applied to the gate electrode layer 155 and the magnitude of the voltage applied to the gate electrode layer 155. When a voltage greater than the threshold voltage is applied to the gate electrode layer 155 and the semiconductor device is turned on, a channel may be created in the depletion region DPR. Accordingly, movement of the carrier may occur in the drift region DTR. If a voltage lower than the threshold voltage is applied to the gate electrode layer 155 or no voltage is applied, the channel path may be blocked in the depletion region DPR and carrier movement may not occur.

The barrier layer 136 may include nitride including a material from the Group III-V materials, for example, Al, Ga, In, B, or a combination thereof. The barrier layer 136 may include AlₓIn_{y}Ga_{1-x-y}N (0≤x≤1, 0≤y≤1, x+y≤1). For example, the barrier layer 136 may include AIN, GaN, InN, InGaN, AlGaN, AlInN, AllnGaN, or a combination thereof. The energy bandgap of the barrier layer 136 can be adjusted by a composition ratio of Al or In.

The barrier layer 136 may include a semiconductor material having different characteristics from the channel layer 132. The barrier layer 136 may be different from the channel layer 132 in at least one of polarization characteristics, energy bandgap, and lattice constant. In an embodiment, the barrier layer 136 includes a material having a different energy bandgap than the channel layer 132. The barrier layer 136 may have a higher energy bandgap than the channel layer 132 and may have a higher electrical polarization rate than the channel layer 132. The two-dimensional electron gas 134 may be induced in the channel layer 132, which has a relatively low electrical polarization rate, by the barrier layer 136. In this regard, the barrier layer 136 may also be called a channel supply layer or a two-dimensional electron gas supply layer. The two-dimensional electron gas 134 may be formed within the portion of the channel layer 132 under the interface between the channel layer 132 and the barrier layer 136. The two-dimensional electron gas 134 may have very high electron mobility.

The gate electrode layer 155 is located on the barrier layer 136. The gate electrode layer 155 may be overlapped with a portion of the barrier layer 136 in the third direction D3. The gate electrode layer 155 may be overlapped with a portion of the drift region DTR of the channel layer 132 in the third direction D3. The gate electrode layer 155 may be located between the source electrode 173 and the drain electrode 175 in the second direction D2. The gate electrode layer 155 may be spaced apart from the source electrode 173 and the drain electrode 175 in the second direction D2. The gate electrode layer 155 may extend along the first direction D1 on a plane. For example, the gate electrode layer 155 may have a bar shape extending lengthwise along the first direction D1 on a plane.

The gate electrode layer 155 may include a conductive material. For example, the gate electrode layer 155 may include a metal, a metal alloy, conductive metal nitride, metal silicide, a doped semiconductor material, conductive metal oxide, or conductive metal oxynitride. For example, the gate electrode layer 155 may be made of titanium nitride (TiN), tantalum carbide (TaC), tantalum nitride (TaN), titanium silicon nitride (TiSiN), tantalum silicon nitride (TaSiN), tantalum titanium nitride (TaTiN), titanium aluminum nitride (TiAIN), tantalum aluminum nitride (TaAlN), tungsten nitride (WN), ruthenium (Ru), titanium aluminum (TiAl), titanium aluminum carbonitride (TiAIC-N), titanium aluminum carbide (TiAlC), titanium carbide (TiC), tantalum carbonitride (TaCN), tungsten (W), aluminum (Al), copper (Cu), cobalt (Co), titanium (Ti), tantalum (Ta), nickel (Ni), platinum (Pt) , nickel platinum (Ni-Pt), niobium (Nb), niobium nitride (NbN), niobium carbide (NbC), molybdenum (Mo), molybdenum nitride (MoN), molybdenum carbide (MoC), tungsten carbide (WC), rhodium. (Rh), palladium (Pd), iridium (Ir), osmium (Os), silver (Ag), gold (Au), zinc (Zn), vanadium (V), or a combination thereof, but is not limited thereto. The gate electrode layer 155 may be made of a single layer or multiple layers.

Although not shown, in some embodiments, a hardmask layer may further be included on the gate electrode layer 155. The hardmask layer may be a hardmask used when patterning a gate electrode material layer or a gate semiconductor layer in the process of forming a gate electrode layer 155. However, the hardmask layer may be removed depending on the etching conditions during the etching of the gate electrode material layer or depending on the cleaning conditions after etching. For example, the hard mask layer may include silicon oxide, silicon nitride, silicon oxynitride, or a combination thereof.

The gate semiconductor layer 152 is located between the barrier layer 136 and the gate electrode layer 155. The gate semiconductor layer 152 may be located directly on the barrier layer 136 and the gate electrode layer 155 may be located directly on the gate semiconductor layer 152. The gate electrode layer 155 may be in Schottky contact with the gate semiconductor layer 152. However, it is not limited to this, and in some cases, the gate electrode layer 155 may be in ohmic contact with the gate semiconductor layer 152. The gate semiconductor layer 152 may be overlapped with the gate electrode layer 155 in the third direction D3. The upper surface of the gate semiconductor layer 152 may be entirely covered by the gate electrode layer 155.

The gate semiconductor layer 152 may be located between the source electrode 173 and the drain electrode 175 in the second direction D2. The gate semiconductor layer 152 may be spaced apart from the source electrode 173 and the drain electrode 175 in the second direction D2. The gate semiconductor layer 152 may be located closer to the source electrode 173 than the drain electrode 175. For example, a separation distance between the gate semiconductor layer 152 and the source electrode 173 may be smaller than a separation distance between the gate semiconductor layer 152 and the drain electrode 175.

The gate semiconductor layer 152 may include nitride including a material from the Group III-V materials, for example, Al, Ga, In, B, or a combination thereof. The gate semiconductor layer 152 may include AlₓIn_{y}Ga_{1-x-y}N (0≤x≤1, 0≤y≤1, x+y≤1). For example, the gate semiconductor layer 152 may include AIN, GaN, InN, InGaN, AlGaN, AllnN, AlInGaN, or a combination thereof. The gate semiconductor layer 152 may include a material having an energy bandgap different from that of the barrier layer 136. For example, the gate semiconductor layer 152 may include GaN, and the barrier layer 136 may include AlGaN. The gate semiconductor layer 152 may be doped with a predetermined impurity. The impurity doped into the gate semiconductor layer 152 may be a p-type dopant that can provide holes. For example, the gate semiconductor layer 152 may include GaN doped with p-type impurities. For example, the gate semiconductor layer 152 may be made of a p-GaN layer. However, it is not limited to this, and the gate semiconductor layer 152 may be a p-AlGaN layer. The impurity doped into the gate semiconductor layer 152 may be magnesium (Mg). The gate semiconductor layer 152 may be made of a single layer or multiple layers.

A depletion region DPR may be formed in the channel layer 132 by the gate semiconductor layer 152. The depletion region DPR may be located within the drift region DTR and may have a narrower width than the drift region DTR. As the gate semiconductor layer 152 has a different energy bandgap than the barrier layer 136 is located on the barrier layer 136, a level of the energy band of a portion of the barrier layer 136 that is overlapped with the gate semiconductor layer 152 may be increased. Accordingly, the depletion region DPR may be formed in the area of the channel layer 132 that is overlapped with the gate semiconductor layer 152. The depletion region DPR may be a region in the channel path of the channel layer 132 where the two-dimensional electron gas 134 is not formed or may have a lower electron concentration than the remaining regions. For example, the depletion region DPR may refer to a region where the flow of the two-dimensional electron gas 134 is interrupted within the drift region DTR. As the depletion region DPR is generated, current does not flow between the source electrode 173 and the drain electrode 175, and the channel path may be blocked. Accordingly, the semiconductor device may have normally-off characteristics.

For example, the semiconductor device may be a normally-off semiconductor device (HEMT, High Electron Mobility Transistor). In a normal state in which no voltage is applied to the gate electrode layer 155, a depletion region DPR exists and the semiconductor device may be in an off state. Although not shown, when a voltage higher than the threshold voltage is applied to the gate electrode layer 155, the depletion region DPR disappears, and the two-dimensional electron gas 134 may be connected without being disconnected within the drift region DTR. For example, the two-dimensional electron gas 134 may be formed throughout the channel path between the source electrode 173 and the drain electrode 175, and the semiconductor device may be in an on state. In summary, the semiconductor device may include semiconductor layers with different electrical polarization characteristics, and a semiconductor layer with a relatively high polarization rate can induce two-dimensional electron gas 134 in another semiconductor layer that forms heterojunction therewith. This two-dimensional electron gas 134 can be used as a channel between the source electrode 173 and the drain electrode 175, and the continuation or interruption of the flow of the two-dimensional electron gas 134 can be controlled by the bias voltage applied to the gate electrode layer 155. In the gate-off state, the flow of the two-dimensional electron gas 134 is blocked, and thus current may not flow between the source electrode 173 and the drain electrode 175. In the gate-on state, the two-dimensional electron gas 134 continues to flow, and thus current may flow between the source electrode 173 and the drain electrode 175.

Although the case where the semiconductor device is a normally-off high electron mobility transistor has been described above, the inventive concept is not limited thereto. For example, the semiconductor device may be a normally-on high electron mobility transistor. In the case of a normally-on high electron mobility transistor, the gate semiconductor layer 152 may be omitted, and accordingly, the gate electrode layer 155 may be located directly on the barrier layer 136. For example, the gate electrode layer 155 may contact the barrier layer 136. However, the inventive concept is not limited thereto, and a gate dielectric layer may be interposed between the gate electrode layer 155 and the barrier layer 136. In this structure, the two-dimensional electron gas 134 can be used as a channel while no voltage is applied to the gate electrode layer 155, and current may flow between the source electrode 173 and the drain electrode 175. Additionally, when a negative voltage is applied to the gate electrode layer 155, a depletion region DPR in which the flow of the two-dimensional electron gas 134 is cut off may be generated at the bottom of the gate electrode layer 155.

The buffer layer 120, channel layer 132, barrier layer 136, and gate semiconductor layer 152 described above may be sequentially stacked on the substrate 110. In the semiconductor device, at least one of the buffer layer 120, the channel layer 132, the barrier layer 136, and the gate semiconductor layer 152 may be omitted. The buffer layer 120, channel layer 132, barrier layer 136, and gate semiconductor layer 152 may be made of the same semiconductor material, and considering the role of each layer and the performance required for the semiconductor device, a material composition ratio of each layer may be different.

The semiconductor device may further include a first protective layer 156, a second protective layer 140, a third protective layer 150, a fourth protective layer 160, or a combination thereof, on the barrier layer 136 and the gate electrode layer 155. For example, the semiconductor device may include a first protective layer 156, a second protective layer 140 on the first protective layer 156, a third protective layer 150 on the second protective layer 140, and a fourth protective layer 160 on the third protective layer 150.

The first protective layer 156 may cover the upper surface of the barrier layer 136 and the gate electrode layer 155, and may cover the side surface of the gate electrode layer 155 and the side surface of the gate semiconductor layer 152. The lower surface of the first protective layer 156 may be in contact with the barrier layer 136, the gate electrode layer 155, and the gate semiconductor layer 152. The upper surface of the first protective layer 156 may be in contact with the second protective layer 140. The second to fourth protective layers 140, 150, and 160 can be separated from the barrier layer 136, the gate electrode layer 155, and the gate semiconductor layer 152 by the first protective layer 156. Therefore, the second to fourth protective layers 140, 150, and 160 may not be in contact with the barrier layer 136, the gate electrode layer 155, and the gate semiconductor layer 152.

The barrier layer 136 or the gate electrode layer 155, etc., may be protected by the first to fourth protective layers 156, 140, 150, and 160 and may be separated from other components. The first to fourth protective layers 156, 140, 150, and 160 may include an insulating material. For example, the first to fourth protective layers 156, 140, 150, and 160 may include oxides such as SiO₂ or Al₂O₃. As another example, the first to fourth protective layers 156, 140, 150, and 160 may include a nitride such as SiN or an oxynitride such as SiON. The first to fourth protective layers 156, 140, 150, and 160 may include the same material or may include different materials. When the first to fourth protective layers 156, 140, 150, and 160 are made of the same material, the boundaries between the first to fourth protective layers 156, 140, 150, and 160 may not be discernable (e.g., they may be part of a single homogenous layer). The first to fourth protective layers 156, 140, 150, and 160 may each be formed of a single layer or multiple layers.

The thickness T_140 of the second protective layer 140 in the third direction D3 may be smaller than or equal to the thickness T_156 of the first protective layer 156 in the third direction D3. The thickness T_150 of the third protective layer 150 in the third direction D3 may be greater than the thickness T_156 of the first protective layer 156 in the third direction D3. The thickness T_160 of the fourth protective layer 160 in the third direction D3 may be greater than the thickness T_150 of the third protective layer 150 in the third direction D3.

Here, the thicknesses T_156, T_140, T_150, and T_160 of the first to fourth protective layers 156, 140, 150, and 160 in the third direction D3 may be defined as the shortest length in the third direction D3 at a position located on the drift region DTR between the gate electrode layer 155 and the drain electrode 175 and not overlapped with the first to third field dispersion layers 177M0, 177M1, and 177M2 in the third direction D3.

The source electrode 173 and the drain electrode 175 may be located on the channel layer 132. The source electrode 173 and the drain electrode 175 may be spaced apart from each other in the second direction D2, and a gate electrode layer 155 and a gate semiconductor layer 152 may be located between the source electrode 173 and the drain electrode 175. The gate electrode layer 155 and the gate semiconductor layer 152 are spaced apart from the source electrode 173 and the drain electrode 175 in the second direction D2. The source electrode 173 may be electrically connected to the channel layer 132 on one side of the gate electrode layer 155. The drain electrode 175 may be electrically connected to the channel layer 132 on the other side of the gate electrode layer 155. The source electrode 173 and the drain electrode 175 may be located outside the drift region DTR of the channel layer 132. The interface between the source electrode 173 and the channel layer 132 may be one edge of the drift region DTR. Similarly, the interface between the drain electrode 175 and the channel layer 132 may be the other edge of the drift region DTR. However, the inventive concept is not limited thereto, and the source electrode 173 and the drain electrode 175 need not be located outside the drift region DTR of the channel layer 132. The channel layer 132 need not be recessed, and the source electrode 173 and the drain electrode 175 may be located on the upper surface of the channel layer 132. The bottom surfaces of the source electrode 173 and the drain electrode 175 may be in contact with the upper surface of the channel layer 132. Additionally, the barrier layer 136 need not be recessed. The source electrode 173 and the drain electrode 175 may be located on the upper surface of the barrier layer 136. For example, the lower surfaces of the source electrode 173 and the drain electrode 175 may be in contact with the upper surface of the barrier layer 136. The portion of the channel layer 132 in contact with the source electrode 173 and the drain electrode 175 may be highly doped. Carriers passing through the two-dimensional electron gas 134 can be transferred to the source electrode 173 and the drain electrode 175 through a portion of the channel layer 132 that is highly doped, i.e., the upper portion of the two-dimensional electron gas 134. The source electrode 173 and the drain electrode 175 may not be in contact with the two-dimensional electron gas 134 in a horizontal direction (e.g., the first direction D1 or the second direction D2). The horizontal direction may refer to a direction parallel to the upper surface of the channel layer 132 or the barrier layer 136.

The source electrode 173 and the drain electrode 175 may extend along the first direction D1 on a plane (e.g., a horizontal place defined by the first direction D1 and the second direction D2). For example, the source electrode 173 and the drain electrode 175 may have a rod shape extending lengthwise along the first direction D1 on a plane. The source electrode 173 and the drain electrode 175 may extend in parallel directions. The source electrode 173 and the drain electrode 175 may extend in a direction parallel to the gate electrode layer 155.

The source electrode 173 and the drain electrode 175 may include a conductive material. For example, the source electrode 173 and the drain electrode 175 may include a metal, a metal alloy, conductive metal nitride, metal silicide, a doped semiconductor material, conductive metal oxide, or conductive metal oxynitride. For example, the source electrode 173 and the drain electrode 175 may be made of titanium nitride (TiN), tantalum carbide (TaC), tantalum nitride (TaN), titanium silicon nitride (TiSiN), tantalum silicon nitride (TaSiN), tantalum titanium nitride (TaTiN), titanium aluminum nitride (TiAIN), tantalum aluminum nitride (TaAIN), tungsten nitride (WN), ruthenium (Ru), titanium aluminum (TiAl), titanium aluminum carbonitride (TiAIC-N), titanium aluminum carbide (TiAIC), titanium carbide (TiC), tantalum carbonitride (TaCN), tungsten (W), aluminum (Al), copper (Cu), cobalt (Co), titanium (Ti), tantalum (Ta), nickel (Ni), platinum (Pt) , nickel platinum (Ni-Pt), niobium (Nb), niobium nitride

(NbN), niobium carbide (NbC), molybdenum (Mo), molybdenum nitride (MoN), molybdenum carbide (MoC), tungsten carbide (WC), rhodium. (Rh), palladium (Pd), iridium (Ir), osmium (Os), silver (Ag), gold (Au), zinc (Zn), vanadium (V), or a combination thereof, but are not limited thereto. The source electrode 173 and the drain electrode 175 may be made of a single layer or multiple layers. The source electrode 173 and the drain electrode 175 may be in ohmic contact with the channel layer 132. A region in contact with the source electrode 173 and the drain electrode 175 within the channel layer 132 may be doped at a relatively high concentration compared to other regions.

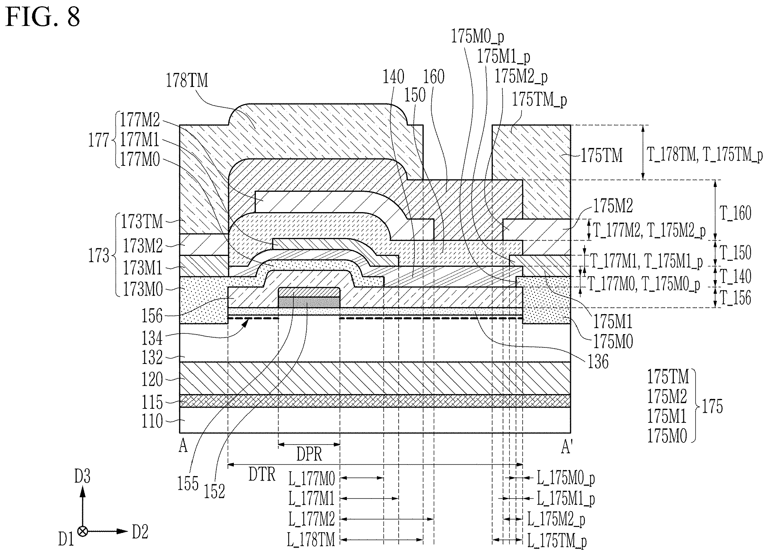

The source electrode 173 may include a first source electrode 173M0, a second source electrode 173M1 of FIG. 8, a third source electrode 173M2 of FIG. 8, a fourth source electrode 173TM of FIG. 8, or a combination thereof. The second source electrode 173M1 may be located on the first source electrode 173M0. The third source electrode 173M2 may be located on the second source electrode 173M1. The fourth source electrode 173TM may be located on the third source electrode 173M2. At least some of the first source electrode 173M0, the second source electrode 173M1, the third source electrode 173M2, or the fourth source electrode 173TM may be omitted. For example, in FIG. 5, the source electrode 173 includes a first source electrode 173M0 and a fourth source electrode 173TM, the fourth source electrode 173TM is located on the first source electrode 173M0, and the second source electrode 173M1 and the third source electrode 173M2 may be omitted.

The first source electrode 173M0 may be in contact with the channel layer 132 and may be electrically connected to the channel layer 132. The second source electrode 173M1, the third source electrode 173M2, and the fourth source electrode 173TM may not be in contact with the channel layer 132 and may be electrically connected to the channel layer 132 through the first source electrode 173M0.

The drain electrode 175 may include a first drain electrode 175M0, a second drain electrode 175M1, a third drain electrode 175M2, and a fourth drain electrode 175TM. The second drain electrode 175M1 may be located on the first drain electrode 175M0. The third drain electrode 175M2 may be located on the second drain electrode 175M1. The fourth drain electrode 175TM may be located on the third drain electrode 175M2. For example, in FIG. 5, a first drain electrode 175M0, a second drain electrode 175M1, a third drain electrode 175M2, and a fourth drain electrode 175TM may be sequentially stacked in a third direction D3. The inventive concept is not limited thereto, and at least some of the first drain electrode 175M0, the second drain electrode 175M1, the third drain electrode 175M2, or the fourth drain electrode 175TM may be omitted.

The first drain electrode 175M0 may be in contact with the channel layer 132 and may be electrically connected to the channel layer 132. The second drain electrode 175M1, the third drain electrode 175M2, and the fourth drain electrode 175TM may not be in contact with the channel layer 132 and may be electrically connected to the channel layer 132 through the first drain electrode 175M0.

The upper surfaces of the first source electrode 173M0 and the first drain electrode 175M0 may be located on the first protective layer 156. The upper surfaces of the first source electrode 173M0 and the first drain electrode 175M0 may be located between the first protective layer 156 and the second protective layer 140. The first source electrode 173M0 and the first drain electrode 175M0 may penetrate through the first protective layer 156 and the barrier layer 136, and the trenches recessing the upper surface of the channel layer 132 may be located so as to be spaced apart from each other on opposite sides of the gate electrode layer 155. A first source electrode 173M0 and a first drain electrode 175M0 may be located in trenches located on both sides of the gate electrode layer 155, respectively. The first source electrode 173M0 and the first drain electrode 175M0 may be formed to fill the inside of the trench. Within the trench, the first source electrode 173M0 and the first drain electrode 175M0 may be in contact with the channel layer 132 and the barrier layer 136. The channel layer 132 may form the bottom surface and side walls of the trench, and the barrier layer 136 may form the side walls of the trench. Accordingly, the first source electrode 173M0 and the first drain electrode 175M0 may be in contact with the upper surface and side surface of the channel layer 132. Additionally, the first source electrode 173M0 and the first drain electrode 175M0 may be in contact with the side surface of the barrier layer 136. For example, the first source electrode 173M0 and the first drain electrode 175M0 may cover the side surfaces of the channel layer 132 and the barrier layer 136. The upper surfaces of the first source electrode 173M0 and the first drain electrode 175M0 may protrude more than the upper surface of the first protective layer 156. Additionally, at least one of the first source electrode 173M0 and the first drain electrode 175M0 may cover at least a portion of the upper surface of the first protective layer 156. A second protective layer 140 may be located on the first source electrode 173M0 and the first drain electrode 175M0. At least a portion of the first source electrode 173M0 and the first drain electrode 175M0 may be covered by a second protective layer 140.

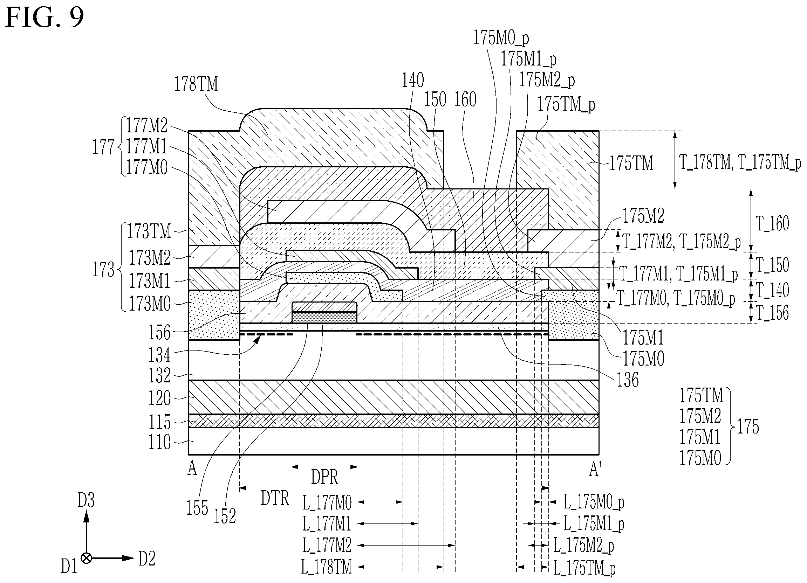

The semiconductor device may further include a first field dispersion layer 177M0 on the first passivation layer 156. The first field dispersion layer 177M0 may be located between the source electrode 173 and the drain electrode 175. The gate electrode layer 155 may be covered by a first field dispersion layer 177M0. The first field dispersion layer 177M0 may be electrically connected to the source electrode 173. For example, in one cross-section (e.g., FIG. 5) cut perpendicular to the first direction D1, the first field dispersion layer 177M0 may be connected to the first source electrode 173M0. Therefore, the first field dispersion layer 177M0 need not be a floating field dispersion layer that is not connected to the source electrode 173 and is spaced apart from the source electrode 173 in the second direction D2. However, in another cross-section (e.g., FIG. 9) cut perpendicularly to the first direction D1, there may be a portion where the first field dispersion layer 177M0 is not connected to the source electrode 173, and the first field dispersion layer 177M0 may be spaced apart from the first source electrode 173M0 in the second direction D2. However, even in this case, the first field dispersion layer 177M0 may be connected to the source electrode 173 in another cross-section cut perpendicular to the first direction D1.

The first field dispersion layer 177M0 may include the same material as the first source electrode 173M0 and may be located in the same layer as the first source electrode 173M0. For example, the first field dispersion layer 177M0 may be formed simultaneously with the first source electrode 173M0 in the same process. In this case, the boundary between the first field dispersion layer 177M0 and the first source electrode 173M0 may not be clear, and the first field dispersion layer 177M0 may be formed integrally with the first source electrode 173M0. However, this is not limited to the first field dispersion layer 177M0 and the first source electrode 173M0 may be a separate component. Additionally, the first field dispersion layer 177M0 may be located in a different layer from the first source electrode 173M0 and may be formed in a different process.

In some embodiments, the first field dispersion layer 177M0 may be electrically connected to the gate electrode layer 155. For example, an opening may be formed in the first protective layer 156 that is overlapped with the gate electrode layer 155, and the first field dispersion layer 177M0 may be connected to the gate electrode layer 155 through the opening. The first field dispersion layer 177M0 may not be connected to the source electrode 173.

The semiconductor device may further include a second field dispersion layer 177M1 on the second protective layer 140. The second field dispersion layer 177M1 may form a field dispersion layer together with the first field dispersion layer 177M0. The second field dispersion layer 177M1 may be located between the source electrode 173 and the drain electrode 175. The second field dispersion layer 177M1 may be overlapped with the gate electrode layer 155 in the third direction D3. The second field dispersion layer 177M1 may be overlapped with the first field dispersion layer 177M0 in the third direction D3. The gate electrode layer 155 and the first field dispersion layer 177M0 may be covered by a second field dispersion layer 177M1. The second field dispersion layer 177M1 may be wider than the width of the first field dispersion layer 177M0. The second field dispersion layer 177M1 may entirely cover the first field dispersion layer 177M0. However, the inventive concept is not limited thereto, and the width, positional relationship, etc. of the first field dispersion layer 177M0 and the second field dispersion layer 177M1 may be changed in various ways.

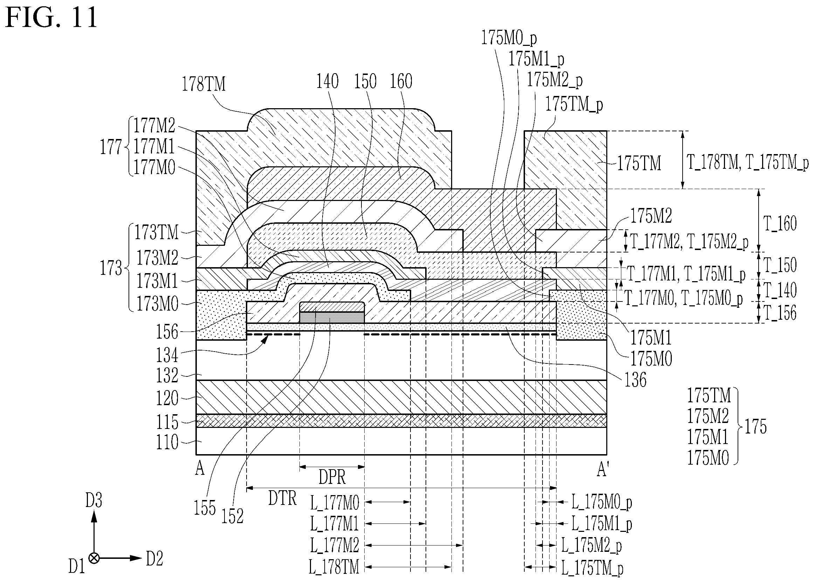

The second field dispersion layer 177M1 may be electrically connected to the source electrode 173. In some embodiments, in one cross-section cut perpendicular to the first direction D1 (e.g., FIG. 11), the second field dispersion layer 177M1 may be connected to the second source electrode 173M1.

Alternatively, in another cross-section cut perpendicular to the first direction D1 (e.g., FIG. 5), the second field dispersion layer 177M1 need not be connected to the second source electrode 173M1 and may be spaced apart from the source electrode 173 in the second direction D2. In this case, the second field dispersion layer 177M1 is connected to the first field dispersion layer 177M0 through the first via 179V0 and may be indirectly connected to the source electrode 173 through the first field dispersion layer 177M0. The first via 179V0 penetrates through the second protective layer 140 and may be located between the second field dispersion layer 177M1 and the first field dispersion layer 177M0 in the third direction D3. The first via 179V0 can electrically connect the second field dispersion layer 177M1 and the first field dispersion layer 177M0 by penetrating through the second protective layer 140.

Accordingly, the second field dispersion layer 177M1 may not be a floating field dispersion layer (e.g., a field dispersion layer that is not connected to a source electrode and is spaced apart from the source electrode). However, in one cross-section (e.g., FIG. 9) cut perpendicular to the first direction D1, there may be a portion where the second field dispersion layer 177M1 is not connected to the source electrode 173. However, even in this case, the second field dispersion layer 177M1 may be connected to the source electrode 173 in another cross-section cut perpendicular to the first direction D1.

The second field dispersion layer 177M1 may include the same material as the second source electrode 173M1 and may be located in the same layer as the second source electrode 173M1. For example, the second field dispersion layer 177M1 may be formed simultaneously with the second source electrode 173M1 in the same process. In this case, the boundary between the second field dispersion layer 177M1 and the second source electrode 173M1 is not apparent, and the second field dispersion layer 177M1 may be formed integrally with the second source electrode 173M1. However, the inventive concept is not limited thereto, and the second field dispersion layer 177M1 may be a separate component separated from the second source electrode 173M1. Additionally, the second field dispersion layer 177M1 may be located in a different layer from the second source electrode 173M1 and may be formed in a different process.

The semiconductor device may further include a third field dispersion layer 177M2 on the third protective layer 150. The third field dispersion layer 177M2 may form a field dispersion layer together with the first field dispersion layer 177M0 and the second field dispersion layer 177M1. The third field dispersion layer 177M2 may be located between the source electrode 173 and the drain electrode 175. The third field dispersion layer 177M2 may be overlapped with the gate electrode layer 155 in the third direction D3. The third field dispersion layer 177M2 may be overlapped with the first field dispersion layer 177M0 and the second field dispersion layer 177M1 in the third direction D3. The gate electrode layer 155, the first field dispersion layer 177M0, and the second field dispersion layer 177M1 may be covered by a third field dispersion layer 177M2. The third field dispersion layer 177M2 may have a larger width than the second field dispersion layer 177M1. The third field dispersion layer 177M2 may entirely cover the second field dispersion layer 177M1. However, the inventive concept is not limited thereto, and the width, positional relationship, etc. of the first field dispersion layer 177M0, the second field dispersion layer 177M1, and the third field dispersion layer 177M2 may be variously changed.

The third field dispersion layer 177M2 may be electrically connected to the source electrode 173. In some embodiments, in one cross-section cut perpendicular to the first direction D1 (e.g., FIG. 11), the third field dispersion layer 177M2 may be connected to the third source electrode 173M2.

Alternatively, in one cross-section cut perpendicular to the first direction D1 (e.g., FIG. 5), the third field dispersion layer 177M2 need not be connected to the third source electrode 173M2 and may be spaced apart from the source electrode 173 in the second direction D2. In this case, the third field dispersion layer 177M2 may be connected to the second field dispersion layer 177M1 through the second via 179V1, connected to the first field dispersion layer 177M0 through the second field dispersion layer 177M1, and indirectly connected to the source electrode 173 through the first field dispersion layer 177M0. The second via 179V1 penetrates the third protective layer 150 and may be located between the third field dispersion layer 177M2 and the second field dispersion layer 177M1 in the third direction D3. The second via 179V1 can electrically connect the third field dispersion layer 177M2 and the second field dispersion layer 177M1 by penetrating through the third protective layer 150.

Accordingly, the third field dispersion layer 177M2 need not be a floating field dispersion layer. For example, the third field dispersion layer 177M2 is connected to the source electrode 173 and is not spaced apart from the source electrode 173 in the second direction D2. However, in one cross-section (e.g., FIG. 9) cut perpendicular to the first direction D1, there may be a portion where the third field dispersion layer 177M2 is not connected to the source electrode 173. However, even in this case, the third field dispersion layer 177M2 may be connected to the source electrode 173 in another cross-section cut perpendicular to the first direction D1.

The third field dispersion layer 177M2 may include the same material as the third source electrode 173M2 and may be located in the same layer as the third source electrode 173M2. The third field dispersion layer 177M2 may be formed simultaneously with the third source electrode 173M2 in the same process. The boundary between the third field dispersion layer 177M2 and the third source electrode 173M2 may not be apparent, and the third field dispersion layer 177M2 may be formed integrally with the third source electrode 173M2. However, the inventive concept is not limited thereto, and the third field dispersion layer 177M2 may be a separate component separated from the third source electrode 173M2. Additionally, the third field dispersion layer 177M2 may be located in a different layer from the third source electrode 173M2 and may be formed in a different process.

In some embodiments, at least one of the first field dispersion layer 177M0, the second field dispersion layer 177M1, or the third field dispersion layer 177M2 may be omitted. For example, the semiconductor device may include a first field dispersion layer 177M0 and need not include a second field dispersion layer 177M1 or a third field dispersion layer 177M2. Alternatively, the semiconductor device may include a second field dispersion layer 177M1 and need not include the first field dispersion layer 177M0 or the third field dispersion layer 177M2. Alternatively, the semiconductor device may include a third field dispersion layer 177M2 and need not include the first field dispersion layer 177M0 or the second field dispersion layer 177M1.

The semiconductor device includes a source wiring layer 178TM which may be on a fourth protective layer 160. The source wiring layer 178TM may be located between the source electrode 173 and the drain electrode 175. The source wiring layer 178TM may be overlapped with the gate electrode layer 155 in the third direction D3. At least a portion of the source wiring layer 178TM may be overlapped with the first field dispersion layer 177M0, the second field dispersion layer 177M1, and the third field dispersion layer 177M2 in a third direction D3.

For example, the source wiring layer 178TM may be located on the field dispersion layer 177 located at the top in the third direction D3. The source wiring layer 178TM may be located on the gate electrode layer 155, the first field dispersion layer 177M0, the second field dispersion layer 177M1, and the third field dispersion layer 177M2. The source wiring layer 178TM may be the metal layer located at the uppermost position in the third direction D3 among the metal layers connected to the source electrode 173.

At least a portion of the gate electrode layer 155, the first field dispersion layer 177M0, the second field dispersion layer 177M1, and the third field dispersion layer 177M2 may be covered by the source wiring layer 178TM. As described below, the source wiring layer 178TM may have a smaller width than the third field dispersion layer 177M2. The source wiring layer 178TM may cover only a portion of the third field dispersion layer 177M2. Accordingly, the source wiring layer 178TM may not operate as a field dispersion layer 177.

The source wiring layer 178TM may be electrically connected to the source electrode 173. In some embodiments, in one cross-section cut perpendicular to the first direction D1 (e.g., FIG. 11), the source wiring layer 178TM may be connected to the fourth source electrode 173TM.

Alternatively, in one cross-section cut perpendicular to the first direction D1 (e.g., FIG. 5), the source wiring layer 178TM need not be connected to the first source electrode 173M0 and may be spaced apart from the source electrode 173 in the second direction D2. In this case, the source wiring layer 178TM may be connected to the third field dispersion layer 177M2 through the third via 179V2, connected to the second field dispersion layer 177M1 through the third field dispersion layer 177M2, connected to the first field dispersion layer 177M0 through the second field dispersion layer 177M1, and indirectly connected to the source electrode 173 through the first field dispersion layer 177M0. The third via 179V2 penetrates through the fourth protective layer 160 and may be located between the source wiring layer 178TM and the third field dispersion layer 177M2 in the third direction D3. The third via 179V2 can electrically connect the source wiring layer 178TM and the third field dispersion layer 177M2 by penetrating through the fourth protective layer 160.

Accordingly, the source wiring layer 178TM may not be a floating electrode. For example, the source wiring layer 178TM may be connected to the source electrode 173 and is not spaced apart from the source electrode 173 in the second direction D2. However, even in this case, the source wiring layer 178TM may be connected to the source electrode 173 in another cross-section cut perpendicular to the first direction D1.

The source wiring layer 178TM may include, for example, the same material as the fourth source electrode 173TM of FIG. 8 and may be located in the same layer as the fourth source electrode 173TM. The source wiring layer 178TM may be formed simultaneously with the fourth source electrode 173TM in the same process. The boundary between the source wiring layer 178TM and the fourth source electrode 173TM may not be apparent, and the source wiring layer 178TM may be formed integrally with the fourth source electrode 173TM. However, the inventive concept is not limited to the above, and the source wiring layer 178TM may be a separate component separated from the fourth source electrode 173TM. Additionally, the source wiring layer 178TM may be located in a different layer from the fourth source electrode 173TM and may be formed in a different process.

The first drain electrode 175M0 may have a first protruding portion 175M0_p protruding in the second direction D2. The first protruding portion 175M0_p may protrude in the second direction D2 from the upper portion of the first drain electrode 175M0. Here, the upper surface of the first protruding portion 175M0_p may be located at a higher level than the upper surface of the first drain electrode 175M0. However, the inventive concept is not limited thereto, and the upper surface of the first protruding portion 175M0_p and the upper surface of the first drain electrode 175M0 may be located at the same or substantially the same level.

As described above, the first drain electrode 175M0 is formed to penetrate through the first protective layer 156 and the barrier layer 136 and fill the inside of the trench that recesses the upper surface of the channel layer 132, so that the first protruding portion 175M0_p may protrude in the second direction D2 toward the second protective layer 140 and may be located on the first protective layer 156. Therefore, at least a portion of the first protruding portion 175M0_p may be overlapped with the drift region DTR in the third direction D3.

The second drain electrode 175M1 may have a second protruding portion 175M1_p protruding in the second direction D2. The second protruding portion 175M1_p may protrude in the second direction D2 from the upper portion of the second drain electrode 175M1. Here, the upper surface of the second protruding portion 175M1_p may be located at a higher level than the upper surface of the second drain electrode 175M1. However, the inventive concept is not limited thereto, and the upper surface of the second protruding portion 175M1_p and the upper surface of the second drain electrode 175M1 may be located at the same or substantially the same level.

The second drain electrode 175M1 is formed to fill the inside of a trench that penetrates the second protective layer 140 and exposes the upper surface of the first drain electrode 175M0, so that the second protruding portion 175M1_p may protrude in the second direction D2 toward the third protective layer 150 and may be located on the second protective layer 140. Therefore, at least a portion of the second protruding portion 175M1_p may be overlapped with the drift region DTR in the third direction D3.

The third drain electrode 175M2 may have a third protruding portion 175M2_p protruding in the second direction D2. The third protruding portion 175M2_p may protrude in the second direction D2 from the upper portion of the third drain electrode 175M2. Here, the upper surface of the third protruding portion 175M2_p may be located at a higher level than the upper surface of the third drain electrode 175M2. However, the inventive concept is not limited thereto, and the upper surface of the third protruding portion 175M2_p and the upper surface of the third drain electrode 175M2 may be located at the same or substantially the same level.

The third drain electrode 175M2 is formed to fill the inside of a trench that penetrates the third protective layer 150 and exposes the upper surface of the second drain electrode 175M1, so that the third protruding portion 175M2_p may protrude in the second direction D2 toward the fourth protective layer 160 and may be located on the third protective layer 150. Therefore, at least a portion of the third protruding portion 175M2_p may be overlapped with the drift region DTR in the third direction D3.

The fourth drain electrode 175TM may have a fourth protruding portion 175TM_p protruding in the second direction D2. The fourth protruding portion 175TM_p may protrude in the second direction D2 from the upper portion of the fourth drain electrode 175TM. Here, the upper surface of the fourth protruding portion 175TM_p may be located at a higher level than the upper surface of the fourth drain electrode 175TM. However, the inventive concept is not limited thereto, and the upper surface of the fourth protruding portion 175TM_p and the upper surface of the fourth drain electrode 175TM may be located at the same or substantially the same level.

The fourth drain electrode 175TM is formed to fill the inside of a trench that penetrates through the fourth protective layer 160 and exposes the upper surface of the third drain electrode 175M2, so that the fourth protruding portion 175TM_p may protrude in the second direction D2 toward the source wiring layer 178TM and be located on the fourth protective layer 160. Therefore, at least a portion of the fourth protruding portion 175TM_p may be overlapped with the drift region DTR in the third direction D3.

The first to fourth protruding portions 175M0_p, 175M1_p, 175M2_p, and 175TM_p may include the same material as the first to fourth drain electrodes 175M0, 175M1, 175M2, and 175TM, respectively, and may be located in the same layer as the first to fourth drain electrodes 175M0, 175M1, 175M2, and 175TM. For example, the first to fourth protruding portions 175M0_p, 175M1_p, 175M2_p, and 175TM_p may be formed simultaneously with the first to fourth drain electrodes 175M0, 175M1, 175M2, and 175TM, respectively, in the same process. In this case, the boundaries between each of the first to fourth protruding portions 175M0_p, 175M1_p, 175M2_p, and 175TM_p and the first to fourth drain electrodes 175M0, 175M1, 175M2, and 175TM is not clear, and each of the first to fourth protruding portions 175M0_p, 175M1_p, 175M2_p, and 175TM_p can be formed integrally with the first to fourth drain electrodes 175M0, 175M1, 175M2, and 175TM. However, the inventive concept is not limited thereto, and each of the first to fourth protruding portions 175M0_p, 175M1_p, 175M2_p, and 175TM_p may be a separate component separated from the first to fourth drain electrodes 175M0, 175M1, 175M2, and 175TM. Additionally, each of the first to fourth protruding portions 175M0_p, 175M1_p, 175M2_p, and 175TM_p may be formed in a different process from the first to fourth drain electrodes 175M0, 175M1, 175M2, and 175TM.

In some embodiments, at least one of the first to fourth protruding portions 175M0_p, 175M1_p, 175M2_p, and 175TM_p may be omitted. For example, the semiconductor device may include a first protruding portion 175M0_p and need not include second to fourth protruding portions 175M1_p, 175M2_p, and 175TM_p. Alternatively, the semiconductor device may include the second protruding portion 175M1_p and not include the first, third, and fourth protruding portions 175M0_p, 175M2_p, and 175TM_p. Alternatively, the semiconductor device may include a third protruding portion 175M2_p and not include the first, second, and fourth protruding portions 175M0_p, 175M1_p, and 175TM_p. Alternatively, the semiconductor device may include a fourth protruding portion 175TM_p and need not include the first to third protruding portions 175M0_p, 175M1_p, and 175M2_p.

The distance by which a first component extends beyond a second component with which it overlaps in the third direction D3 is referred to hereafter as an extension length. For example, the extension length L_178TM of the source wiring layer 178TM in the second direction D2 may be smaller than the extension length of the field dispersion layer 177 in the second direction D2. For example, the extension length L_178TM of the source wiring layer 178TM in the second direction D2 may be smaller than the extension length L_177M2 of the third field dispersion layer 177M2 in the second direction D2. The extension length L_178TM of the source wiring layer 178TM in the second direction D2 may be smaller than the extension length L_177M1 of the second field dispersion layer 177M1 in the second direction D2. The extension length L_178TM of the source wiring layer 178TM in the second direction D2 may be smaller than the extension length L_177M0 of the first field dispersion layer 177M0 in the second direction D2.

Here, the extension length L_178TM of the source wiring layer 178TM in the second direction D2 may be defined as a length from any point of the source wiring layer 178TM that is overlapped with the end of the gate electrode layer 155 in the third direction D3 to one end of the source wiring layer 178TM in the second direction D2 away from the source electrode 173. For example, the extension length L_178TM of the source wiring layer 178TM in the second direction D2 may be a length that is overlapped with the drift region DTR located between the gate electrode layer 155 and the drain electrode 175 in the third direction D3. Additionally, the extension length L_178TM of the source wiring layer 178TM in the second direction D2 may be the shortest length in the second direction D2 among the lengths satisfying the above conditions.

In addition, the extension lengths L_177M0, L_177M1, and L_177M2 of the first to third field dispersion layers 177M0, 177M1, and 177M2 in the second direction D2 may be defined as a length from a point of each of the first to third field dispersion layers 177M0, 177M1, and 177M2 that is overlapped with the end of the gate electrode layer 155 in the third direction D3 to one end of each of the first to third field dispersion layers 177M0, 177M1, and 177M2 in the second direction D2 away from the source electrode 173. For example, the extension lengths L_177M0, L_177M1, and L_177M2 of the first to third field dispersion layers 177M0, 177M1, and 177M2 in the second direction D2 may be a length that is overlapped with the drift region DTR located between the gate electrode layer 155 and the drain electrode 175 in the third direction D3. Additionally, the extension lengths L_177M0, L_177M1, and L_177M2 of the first to third field dispersion layers 177M0, 177M1, and 177M2 in the second direction D2 may be the shortest lengths in the second direction D2 among the lengths satisfying the above condition.

Additionally, the extension length L_177M0 of the first field dispersion layer 177M0 in the second direction D2 may be smaller than the extension length L_177M1 of the second field dispersion layer 177M1 in the second direction D2. The extension length L_177M1 of the second field dispersion layer 177M1 in the second direction D2 may be smaller than the extension length L_177M2 of the third field dispersion layer 177M2 in the second direction D2.

Accordingly, at least some of the first to third field dispersion layers 177M0, 177M1, and 177M2 need not be overlapped with other field dispersion layers 177 in the third direction D3, or may not be covered by other field dispersion layers 177, and may be directly overlapped with a drift region DTR located between the gate electrode layer 155 and the drain electrode 175 in the third direction D3. Therefore, the first to third field dispersion layers 177M0, 177M1, and 177M2 may operate as field dispersion layers 177.

On the other hand, in the drift region DTR located between the gate electrode layer 155 and the drain electrode 175, the entire source wiring layer 178TM is overlapped with at least one of the first to third field dispersion layers 177M0, 177M1, and 177M2 in the third direction D2. For example, one end of the source wiring layer 178TM in the second direction D2 away from the source electrode 173 is overlapped with the field dispersion layer 177 in the third direction D3. For example, a field dispersion layer 177 may be located between one end of the source wiring layer 178TM and the barrier layer 136 in the third direction D3. In this way, since the source wiring layer 178TM is concealed by at least one of the first to third field dispersion layers 177M0, 177M1, and 177M2 in the third direction D3, it is not directly overlapped with the drift region DTR located between the gate electrode layer 155 and the drain electrode 175 in the third direction D3. Therefore, the source wiring layer 178TM does not function as a field dispersion layer 177.

Additionally, in the drain electrode 175, the length L_175M0_p of the first protruding portion 175M0_p in the second direction D2 may be smaller than the length L_175M1_p of the second protruding portion 175M1_p in the second direction D2. The length L_175M1_p of the second protruding portion 175M1_p in the second direction D2 may be smaller than the length L_175M2_p of the third protruding portion 175M2_p in the second direction D2. The length L_175M2_p of the third protruding portion 175M2_p in the second direction D2 may be smaller than the length L_175TM_p of the fourth protruding portion 175TM_p in the second direction D2. The length L_175TM_p of the fourth protruding portion 175TM_p in the second direction D2 may be greater than the lengths L_175M0_p, L_175M1_p, and L_175M2_p of the first to third protruding portions 175M0_p, 175M1_p, and 175M2_p in the second direction D2.

Here, the lengths L_175M0_p, L_175M1_p, L_175M2_p, and L_175TM_p of the first to fourth protruding portions 175M0_p, 175M1_p, 175M2_p, and 175TM_p in the second direction D2 may be defined as, for example, the lengths from the portion where the first to fourth protruding portions 175M0_p, 175M1_p, 175M2_p, and 175TM_p meet the first to fourth drain electrodes 175M0, 175M1, 175M2, and 175TM to one end in the second direction D2 away from the first to fourth drain electrodes 175M0, 175M1, 175M2, and 175TM. there is. For example, the lengths L_175M0_p, L_175M1_p, L_175M2_p, and L_175TM_p of the first to fourth protruding portions 175M0_p, 175M1_p, 175M2_p, and 175TM_p in the second direction D2 may be lengths that overlap the drift region DTR located between the gate electrode layer 155 and the drain electrode 175 in the third direction D3. Additionally, the lengths L_175M0_p, L_175M1_p, L_175M2_p, and L_175TM_p of the first to fourth protruding portions 175M0_p, 175M1_p, 175M2_p, and 175TM_p in the second direction D2 may be the shortest lengths in the second direction D2 among the lengths satisfying the above condition.

As the area of a semiconductor device increases, the voltage drop due to wiring resistance increases, and the influence of wiring resistance becomes greater in the case of low-voltage, large-area devices. To improve this, it may be necessary to increase the width of the wiring. In a structure where a field dispersion layer 177 connected to a source electrode 173 is applied to efficiently disperse the E-Field, for example, referring to FIG. 4, if there is no source wiring layer 178TM and the fourth drain electrode 175TM, the voltage drop due to wiring resistance may not be large on the source electrode 173 side because the width of the third field dispersion layer 177M2 is wide, but on the drain electrode 175 side, the voltage drop due to wiring resistance is relatively large because the third drain electrode 175M2 does not extend as much in the second direction D2. Accordingly, the width of the fourth drain electrode 175TM, which corresponds to the drain wiring layer on the drain electrode 175 side, may be widened to improve the wiring resistance of the device.

As described above, for example, the first to third field dispersion layers 177M0, 177M1, and 177M2 have longer extension lengths L_177M0, L_177M1, and L_177M2 in the second direction D2 as they are located higher in the third direction D3, but the extension length L_178TM of the source wiring layer 178TM on the third field dispersion layer 177M2, which is located highest in the third direction D3 among the field dispersion layers 177, in the second direction D2 is shorter than the extension length L_177M2 of the third field dispersion layer 177M2 in the second direction D2.

Since the source wiring layer 178TM of the source electrode 173 does not function as a field dispersion layer, as the extension length L_178TM in the second direction D2 decreases, the length L_175TM_p of the fourth protruding portion 175TM_p in the second direction D2 in the drain electrode 175 can further increase. For example, the first to fourth drain electrodes 175M0, 175M1, 175M2, and 175TM have first to fourth protruding portions 175M0_p, 175M1_p, 175M2_p, and 175TM_p, respectively, and the first to fourth protruding portions 175M0_p, 175M1_p, 175M2_p, and 175TM_p may have lengths L_175M0_p, L_175M1_p, L_175M2_p, and L_175TM_p extending in the second direction D2 toward the drift region that become longer as they are located higher in the third direction D3.

Accordingly, by using the field dispersion layer 177, the electric field peak of the channel layer 132 is reduced and the electric field of the channel layer 132 is efficiently dispersed to flatten the profile, while additionally reducing the extension length L_178TM of the source wiring layer 178TM located on the field dispersion layer 177 in the second direction D2 and increasing the length L_175TM_p of the fourth protruding portion 175TM_p on the drain electrode 175 side in the second direction D2, thereby reducing the wiring resistance on the drain electrode 175 side.

For example, when the length L_175TM_p of the fourth protruding portion 175TM_p of the drain electrode 175 in the second direction D2 is 2 µm, when the length of the gate electrode layer 155 in the first direction D1 increases from about 0.5 mm to about 1.3 mm, the resistance increase is 8%, whereas when the length L_175TM_p of the fourth protruding portion 175TM_p of the drain electrode 175 in the second direction D2 is 6 µm, when the length of the gate electrode layer 155 in the first direction D1 increases from about 0.5 mm to about 1.3 mm, the resistance increase is about 4%, so that the wiring resistance can be improved.

Additionally, the thickness T_177M0 of the first field dispersion layer 177M0 in the third direction D3 may be smaller than the thickness T_177M1 of the second field dispersion layer 177M1 in the third direction D3. The thickness T_177M1 of the second field dispersion layer 177M1 in the third direction D3 may be smaller than the thickness T_177M2 of the third field dispersion layer 177M2 in the third direction D3. The thickness T_177M2 of the third field dispersion layer 177M2 in the third direction D3 may be smaller than the thickness T_178TM of the source wiring layer 178TM in the third direction D3. The thickness T_178TM of the source wiring layer 178TM in the third direction D3 may be greater than the thicknesses T_177M0, T_177M1, and T_177M2 of the first to third field dispersion layers 177M0, 177M1, and 177M2 in the third direction D3.

Here, the thicknesses T_177M0, T_177M1, and T_177M2 of the first to third field dispersion layers 177M0, 177M1, and 177M2 in the third direction D3 may be defined as the shortest length in the third direction D3 from one end of the first to third field dispersion layers 177M0, 177M1, and 177M2 in the second direction D2 away from the source electrode 173. In addition, the thickness T_178TM of the source wiring layer 178TM in the third direction D3 may be defined as the shortest length from one end of the source wiring layer 178TM in the third direction D3 in the second direction D2 away from the source electrode 173.

The thickness T_175M0_p of the first protruding portion 175M0_p in the third direction D3 may be smaller than the thickness T_175M1_p of the second protruding portion 175M1_p in the third direction D3. The thickness T_175M1_p of the second protruding portion 175M1_p in the third direction D3 may be smaller than the thickness T_175M2_p of the third protruding portion 175M2_p in the third direction D3. The thickness T_175M2_p of the third protruding portion 175M2_p in the third direction D3 may be smaller than the thickness T_175TM_p of the fourth protruding portion 175TM_p in the third direction D3. The thickness T_175TM_p in the third direction D3 of the fourth protruding portion 175TM_p may be greater than the thicknesses T_175M0_p, T_175M1_p, and T_175M2_p of the first to third protruding portions 175M0_p, 175M1_p, and 175M2_p in the third direction D3.

Here, the thicknesses T_175M0_p, T_175M1_p, T_175M2_p, and T_175TM_p of the first to fourth protruding portions 175M0_p, 175M1_p, 175M2_p, and 175TM_p in the third direction D3 may be defined as the shortest length from one end of the first to fourth protruding portions 175M0_p, 175M1_p, 175M2_p, and 175TM_p in the third direction D3 away from the drain electrode 175.

The length L_179V0 of the first via 179V0 in the second direction D2 may be smaller than the length L_179V1 of the second via 179V1 in the second direction D2. The length L_179V1 of the second via 179V1 in the second direction D2 may be smaller than the length L_179V2 of the third via 179V2 in the second direction D2.

Additionally, the first angle formed by the sidewall of the first via 179V0 in the second direction D2 and the lower surface of the second protective layer 140 may be greater than the second angle formed by the sidewall of the second via 179V1 in the second direction D2 and the lower surface of the third protective layer 150. The second angle formed by the sidewall of the second via 179V1 in the second direction D2 and the lower surface of the third protective layer 150 may be greater than or equal to the third angle formed by the sidewall of the third via 179V2 in the second direction D2 and the lower surface of the fourth protective layer 160.

Accordingly, even if the thicknesses T_156, T_140, T_150, and T_160 of the first to fourth protective layers 156, 140, 150, and 160 in the third direction D3 become larger as they are positioned higher in the third direction D3, the occurrence of voids due to profile defects can be reduced.

For example, a semiconductor device may include a plurality of gate electrode layers 155, a plurality of source electrodes 173, and a plurality of drain electrodes 175.

The gate electrode layer 155, the source electrode 173, and the drain electrode 175 may have a bar shape that extends long along the first direction D1 on a plane, and the gate electrode layer 155 may be alternately arranged with the source electrode 173 and the drain electrode 175 along the second direction D2. For example, along the second direction D2, the gate electrode layer 155, the source electrode 173, the gate electrode layer 155, the drain electrode 175, the gate electrode layer 155, the source electrode 173, the gate electrode layer 155, the drain electrode 175 may be arranged in this order.

A gate connection portion 155c may be located between a plurality of gate electrode layers 155 spaced apart in the second direction D2. The gate connection portion 155c may extend in the second direction D2 to connect between the gate electrode layers 155. A plurality of gate connection portions 155c may be located between one gate electrode layer 155 and another gate electrode layer 155 spaced apart from the one gate electrode layer 155 in the second direction D2, and the plurality of gate connection portions 155c may be arranged spaced apart from each other at a predetermined interval in the first direction D1 between the gate electrode layers 155. Additionally, the gate semiconductor layer 152 may also be located between the barrier layer 136 and the gate connection portion 155c. The first protective layer 156 may cover the upper surface and side surface of the gate connection portion 155c.

As the source electrode 173 extends in the first direction D1 between the gate electrode layers 155 spaced apart in the second direction D2, the source electrode 173 passes over the gate connection portion 155c. A first protective layer 156 may be located between the source electrode 173 and the gate connection portion 155c. The source electrode 173 and the gate connection portion 155c may not be connected. Additionally, the source electrode 173 may have a gate contact hole CH1 that exposes the gate connection portion 155c in the third direction D3. For example, the first source electrode 173M0 may have a gate contact hole CH1, the gate contact hole CH1 may penetrate the first source electrode 173M0, and a first protective layer 156 and a second protective layer 140 may be stacked within the gate contact hole CH1.

Additionally, the semiconductor device may further include a gate draw out line 193M1 connected to the gate connection portion 155c. A gate draw out line 193M1 may extend in a first direction D1 between one gate electrode layer 155 and another gate electrode layer 155 spaced apart from it in a second direction D2. Accordingly, the gate draw out line 193M1 may pass over and be connected to a plurality of gate connection portions 155c spaced apart at a certain interval in the first direction D1.

The gate draw out line 193M1 may be located on the second protective layer 140. Additionally, the gate draw out line 193M1 may be covered by the third protective layer 150, the fourth protective layer 160, or both.

As described above, since the source electrode 173, for example, the first source electrode 173M0, is spaced apart in the first direction D1 between the gate electrode layers 155 spaced apart in the second direction D2, the gate draw out line 193M1 may be located on the first source electrode 173M0, and the gate draw out line 193M1 and the first source electrode 173M0 may be overlapped with in the third direction D3. A second protective layer 140 may be located between the gate draw out line 193M1 and the first source electrode 173M0. The gate draw out line 193M1 and the first source electrode 173M0 may not be connected.

For example, the gate draw out line 193M1 may include the same material as the second source electrode 173M1 or the second field dispersion layer 177M1 and may be located in the same layer as the second source electrode 173M1 or the second field dispersion layer 177M1. For example, the gate draw out line 193M1 may be formed simultaneously with the second source electrode 173M1 or the second field dispersion layer 177M1 in the same process. In this case, the boundary between the gate draw out line 193M1 and the second source electrode 173M1 or the second field dispersion layer 177M1 may not be apparent, and the gate draw out line 193M1 may be formed integrally with the second source electrode 173M1 or the second field dispersion layer 177M1. However, the inventive concept is not limited thereto, and the gate draw out line 193M1 may be a separate component separated from the second source electrode 173M1 or the second field dispersion layer 177M1. Additionally, the gate draw out line 193M1 may be located in a different layer from the second source electrode 173M1 or the second field dispersion layer 177M1 and may be formed in a different process.

For example, the gate draw out line 193M1 may be connected to the gate connection portion 155c through a gate via 179VG. A gate via 179VG may be located between the gate draw out line 193M1 and the gate connection portion 155c in the third direction D3. The gate via 179VG may be located within the gate contact hole CH1. The gate via 179VG may extend in the third direction D3 through the first protective layer 156 and the second protective layer 140 stacked within the gate contact hole CH1. The gate via 179VG may electrically connect the gate draw out line 193M1 and the gate connection portion 155c.

The gate draw out line 193M1 can be extended in the first direction D1 until it meets the gate signal line 194M1. For example, a gate signal line 194M1 may extend in one second direction D2 and be connected to a gate pad 194TM.

The gate pad 194TM may be located on at least a portion of the gate signal line 194M1. For example, the gate pad 194TM may be located on the fourth protective layer 160, and a third protective layer 150 and a fourth protective layer 160 may be interposed between the gate pad 194TM and the gate signal line 194M1. The gate pad 194TM and the gate signal line 194M1 may be electrically connected by a via or the like penetrating the third protective layer 150 and the fourth protective layer 160.

A source signal line 191M2 may be located on at least a portion of the gate signal line 194M1. The source signal line 191M2 may be located on the third protective layer 150, and the third protective layer 150 may be interposed between the source signal line 191M2 and the gate signal line 194M1. Therefore, the source signal line 191M2 and the gate signal line 194M1 may not be electrically connected.

The source signal line 191M2 extends in the second direction D2 and may be connected to the source pad 191TM. The source signal line 191M2 extends in one second direction D2 and the other second direction D2 along which the gate signal line 194M1 extends and may be connected to the source pad 191TM.

The source pad 191TM can be located on at least a portion of the source signal line 191M2. The source pad 191TM may be located on the fourth protective layer 160, and the fourth protective layer 160 may be interposed between the source pad 191TM and the source signal line 191M2. The source pad 191TM and the source signal line 191M2 may be electrically connected by a via or the like penetrating the fourth protective layer 160. Alternatively, the source wiring layer 178TM may extend in the first direction D1 and be connected to the source pad 191TM.

Additionally, the fourth drain electrode 175TM corresponding to the drain wiring layer can extend in the first direction D1 until it contacts the drain pad 192TM. The fourth drain electrode 175TM and the drain pad 192TM may be electrically connected. For example, the source pad 191TM and the drain pad 192TM may be spaced apart in the first direction D1 with the gate electrode layer 155, the source electrode 173, and the drain electrode 175 interposed therebetween, and may extend in the second direction D2. Accordingly, the source wiring layer 178TM can extend in one first direction D1 until it meets the source pad 191TM, and the fourth drain electrode 175TM can extend in the other first direction D1 until it meets the drain pad 192TM.

The gate pad 194TM, the source pad 191TM, and the drain pad 192TM may each include the same material as the source wiring layer 178TM and the fourth drain electrode 175TM, and may be located in the same layer as the source wiring layer 178TM and the fourth drain electrode 175TM. For example, the gate pad 194TM, the source pad 191TM, and the drain pad 192TM may be formed simultaneously in the same process as the first source wiring layer 178TM and the fourth drain electrode 175TM, respectively. In this case, the boundaries between each of the source pad 191TM and the drain pad 192TM and the source wiring layer 178TM and the fourth drain electrode 175TM are not apparent, and each of the source pad 191TM and the drain pad 192TM may be formed integrally with the source wiring layer 178TM and the fourth drain electrode 175TM. However, the inventive concept is not limited thereto, and each of the source pad 191TM and the drain pad 192TM may be a separate component separated from the source wiring layer 178TM and the fourth drain electrode 175TM. Additionally, each of the gate pad 194TM, the source pad 191TM, and the drain pad 192TM may be located in a different layer from the source wiring layer 178TM and the fourth drain electrode 175TM, and may be formed in a different process.

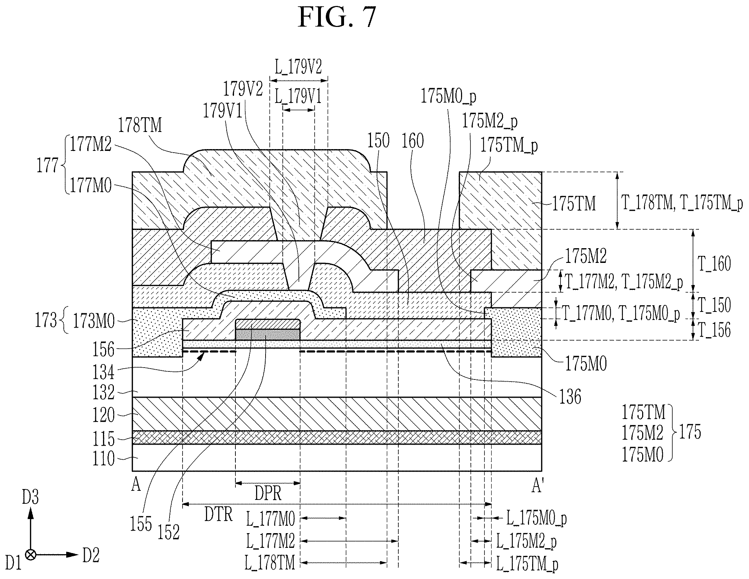

FIG. 7 is a cross-sectional view showing another embodiment, corresponding to FIG. 5.

Since the embodiment shown in FIG. 7 has many of the same parts as the embodiment shown in FIG. 5, description thereof will be omitted and the differences will be mainly explained. Additionally, the same reference numerals are used for the same components as those in the previous embodiment.

Referring to FIG. 7, at least one of the first to fourth source electrodes 173M0, 173M1, 173M2, and 173TM may be omitted, at least one of the first to fourth drain electrodes 175M0, 175M1, 175M2, and 175TM may be omitted, at least one of the first to third field dispersion layers 177M0, 177M1, and 177M2 may be omitted, and at least one of the first to fourth protective layers 156, 140, 150, and 160 may be omitted.

As an example, FIG. 7 illustrates a case where the second source electrode 173M1, the third source electrode 173M2, the fourth source electrode 173TM, the second drain electrode 175M1, the second field dispersion layer 177M1, and the second protective layer 140 are omitted.

For example, the source electrode 173 includes a first source electrode 173M0. A third protective layer 150 and a fourth protective layer 160 may be sequentially stacked between the first source electrode 173M0 and the source wiring layer 178TM. The drain electrode 175 includes a first drain electrode 175M0, a third drain electrode 175M2, and a fourth drain electrode 175TM, and the first drain electrode 175M0, the third drain electrode 175M2, and the fourth drain electrode 175TM may be sequentially stacked in a third direction D3.

The field dispersion layer 177 may include a first field dispersion layer 177M0 and a third field dispersion layer 177M2. The first field dispersion layer 177M0 may be connected to the third field dispersion layer 177M2 through the second via 179V1, and the third field dispersion layer 177M2 may be connected to the source wiring layer 178TM through the third via 179V2.

For example, a first protective layer 156 may be located between the gate electrode layer 155 and the first field dispersion layer 177M0, a third protective layer 150 may be located between the first field dispersion layer 177M0 and the third field dispersion layer 177M2, and a fourth protective layer 160 may be located between the third field dispersion layer 177M2 and the source wiring layer 178TM.

FIG. 8 is a cross-sectional view showing another embodiment, corresponding to FIG. 5.

Since the embodiment shown in FIG. 8 has many of the same parts as the embodiment shown in FIG. 5, description thereof will be omitted and the differences will be mainly explained. Additionally, the same reference numerals are used for the same components as those in the previous embodiment.

Referring to FIG. 8, the source electrode 173 may include first to fourth source electrodes 173M0, 173M1, 173M2, and 173TM. The first to fourth source electrodes 173M0, 173M1, 173M2, and 173TM may be sequentially connected in the third direction D3. The first to fourth source electrodes 173M0, 173M1, 173M2, and 173TM may be electrically connected.

The first to third field dispersion layers 177M0, 177M1, and 177M2 may be connected to the first to third source electrodes 173M0, 173M1, and 173M2, respectively, or may not be connected and may be spaced apart in the second direction D2. Additionally, the source wiring layer 178TM may be connected to the fourth source electrode 173TM or may not be connected and may be spaced apart in the second direction D2.

In FIG. 8, the first field dispersion layer 177M0 is connected to the first source electrode 173M0, the source wiring layer 178TM is connected to the fourth source electrode 173TM, but the second and third field dispersion layers 177M1 and 177M2 are not connected to the second and third source electrodes 173M1 and 173M2, respectively, and are spaced apart in the second direction D2.

Additionally, in FIG. 8, the first via 179V0 connecting the second field dispersion layer 177M1 and the first field dispersion layer 177M0, the second via 179V1 connecting the third field dispersion layer 177M2 and the second field dispersion layer 177M1, and the third via 179V2 connecting the source wiring layer 178TM and the third field dispersion layer 177M2 are not illustrated.

However, even in this case, the second and third field dispersion layers 177M1 and 177M2 are not floating field dispersion layers, which would be the case if they were not connected to the source electrode 173 and were spaced apart from the source electrode 173 in the second direction D2. In another cross-section cut perpendicular to the first direction D1, there may be a portion where the second and third field dispersion layers 177M1 and 177M2 are connected to the source electrode 173.

FIG. 9 is a cross-sectional view showing another embodiment, corresponding to FIG. 8.

Since the embodiment shown in FIG. 9 has many of the same parts as the embodiment shown in FIG. 8, description thereof will be omitted and the differences will be mainly explained. Additionally, the same reference numerals are used for the same components as those in the previous embodiment.

In FIG. 8, a case is illustrated where the first field dispersion layer 177M0 is connected to the first source electrode 173M0.

Referring to FIG. 9, the first field dispersion layer 177M0 may also be spaced apart in the second direction D2 without being connected to the first source electrode 173M0. However, even in this case, the first field dispersion layer 177M0 is not a floating field dispersion layer. In another cross-section cut perpendicular to the first direction D1, there may be a portion where the first field dispersion layer 177M0 is connected to the source electrode 173.

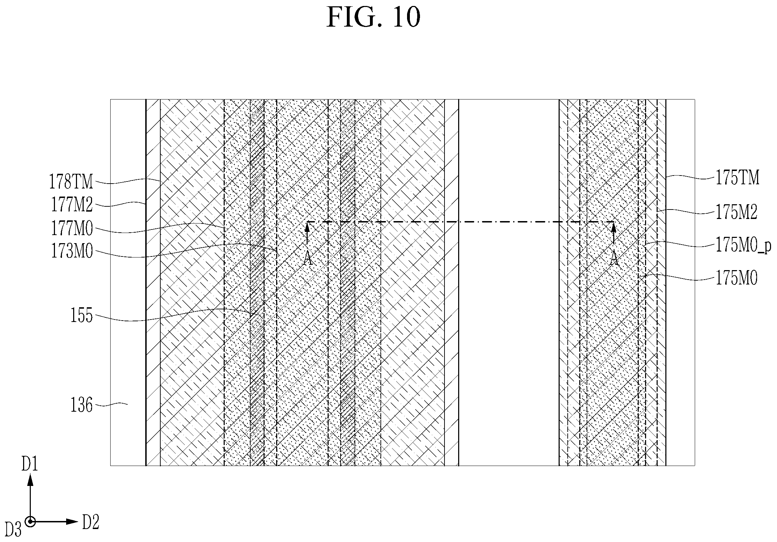

FIG. 10 is a plan view showing a semiconductor device according to an embodiment. FIG. 11 is a cross-sectional view taken along line A-A' of FIG. 10.

Since the embodiments shown in FIGS. 10 and 11 have many of the same parts as the embodiments shown in FIGS. 4 and 5, description thereof will be omitted and the differences will be mainly explained. Additionally, the same reference numerals are used for the same components as those in the previous embodiment.

For clarity and simplicity of illustration, FIG. 10 illustrates a barrier layer 136, a gate electrode layer 155, a first source electrode 173M0, a first drain electrode 175M0, a first protruding portion 175M0_p, a third drain electrode 175M2, a fourth drain electrode 175TM, a first field dispersion layer 177M0, a third field dispersion layer 177M2, and a source wiring layer 178TM, and omits illustrations of the second source electrode 173M1, the third source electrode 173M2, the fourth source electrode 173TM, the second drain electrode 175M1, and the second field dispersion layer 177M1.

Referring to FIGS. 10 and 11, the source electrode 173 may include a first source electrode 173M0, a second source electrode 173M1, a third source electrode 173M2, and a fourth source electrode 173TM. The first source electrode 173M0, the second source electrode 173M1, the third source electrode 173M2, and the fourth source electrode 173TM may be sequentially stacked in the third direction D3. Additionally, the first source electrode 173M0, the second source electrode 173M1, the third source electrode 173M2, and the fourth source electrode 173TM may be electrically connected.

The drain electrode 175 includes a first drain electrode 175M0, a second drain electrode 175M1, a third drain electrode 175M2, and a fourth drain electrode 175TM, and the first drain electrode 175M0, the second drain electrode 175M1, the third drain electrode 175M2, and the fourth drain electrode 175TM may be sequentially stacked in a third direction D3. Additionally, the first drain electrode 175M0, the second drain electrode 175M1, the third drain electrode 175M2, and the fourth drain electrode 175TM may be electrically connected.

The field dispersion layer 177 may include a first field dispersion layer 177M0, a second field dispersion layer 177M1, and a third field dispersion layer 177M2. A first protective layer 156 may be located between the gate electrode layer 155 and the first field dispersion layer 177M0, a second protective layer 140 may be located between the first field dispersion layer 177M0 and the second field dispersion layer 177M1, a third protective layer 150 may be located between the second field dispersion layer 177M1 and the third field dispersion layer 177M2, and a fourth protective layer 160 may be located between the third field dispersion layer 177M2 and the source wiring layer 178TM.

The first field dispersion layer 177M0 may be connected to the first source electrode 173M0, the second field dispersion layer 177M1 may be connected to the second source electrode 173M1, the third field dispersion layer 177M2 may be connected to the third source electrode 173M2, and the source wiring layer 178TM may be connected to the fourth source electrodes 173TM.

While the inventive concept of this this disclosure has been described in connection with what is presently considered to be practical embodiments, it is to be understood that the inventive concept is not limited to the disclosed embodiments, but, on the contrary, is intended to cover various modifications and equivalent arrangements included within the spirit and scope of the appended claims.
Embodiments are set out in the following clauses:
Clause 1. A semiconductor device comprising, a channel layer, a barrier layer located on the channel layer and including a material having an energy band gap different from that of the channel layer, a gate electrode layer located on the barrier layer and extending in the first direction, a gate semiconductor layer between the barrier layer and the gate electrode layer, a source electrode and a drain electrode connected to the channel layer and located spaced apart from the gate electrode layer in a second direction different from the first direction, a field dispersion layer located on the gate electrode layer, connected to the source electrode, and overlapped with the gate electrode layer in a third direction different from the first direction and the second direction, and a source wiring layer located on the field dispersion layer, connected to the source electrode, and overlapped with the gate electrode layer in the third direction, wherein a length from any point of the source wiring layer overlapped with the gate electrode layer in the third direction to one end of the source wiring layer in the second direction away from the source electrode is smaller than a length from any point of the field dispersion layer overlapped with the gate electrode layer in the third direction to one end of the field dispersion layer in the second direction away from the source electrode.
Clause 2. The semiconductor device of clause 1, wherein the semiconductor device comprises a plurality of field dispersion layers, and the source wiring layer is located on the field dispersion layer which is located at the uppermost position in the third direction among the field dispersion layers.
Clause 3. The semiconductor device of clause 2, wherein the field dispersion layer further comprises a first field dispersion layer on the gate electrode, a second field dispersion layer on the first field dispersion layer, a third field dispersion layer on the second field dispersion layer, or a combination thereof, wherein the source wiring layer is located on the field dispersion layer which is located at the uppermost position in the third direction among the first to third field dispersion layers.
Clause 4. The semiconductor device of clause 3, wherein a length from any point of the first field dispersion layer overlapped with the gate electrode layer in the third direction to one end of the first field dispersion layer in the second direction away from the source electrode is smaller than a length from any point of the second field dispersion layer overlapped with the gate electrode layer in the third direction to one end of the second field dispersion layer in the second direction away from the source electrode, a length from any point of the second field dispersion layer overlapped with the gate electrode layer in the third direction to one end of the second field dispersion layer in the second direction away from the source electrode is smaller than a length from any point of the third field dispersion layer overlapped with the gate electrode layer in the third direction to one end of the third field dispersion layer in the second direction away from the source electrode, and a length from any point of the source wiring layer overlapped with the gate electrode layer in the third direction to one end of the source wiring layer in the second direction away from the source electrode is smaller than a length from any point of the third field dispersion layer overlapped with the gate electrode layer in the third direction to one end of the third field dispersion layer in the second direction away from the source electrode.
Clause 5. The semiconductor device of clause 3 or 4, wherein a thickness of the first field dispersion layer in the third direction is smaller than a thickness of the second field dispersion layer in the third direction, a thickness of the second field dispersion layer in the third direction is smaller than a thickness of the third field dispersion layer in the third direction, a thickness of the third field dispersion layer in the third direction is smaller than a thickness of the source wiring layer in the third direction, and a thickness of the source wiring layer in the third direction is greater than a thickness of the first to third field dispersion layers in the third direction.
Clause 6. The semiconductor device of clause 3, 4 or 5, wherein the semiconductor device further comprises a first protective layer covering the gate electrode and located under the first field dispersion layer, a second protective layer on the first protective layer and between the first field dispersion layer and the second field dispersion layer, a third protective layer on the second protective layer and between the second field dispersion layer and the third field dispersion layer, a fourth protective layer on the third protective layer, and between the third field dispersion layer and the source wiring layer, or a combination thereof.
Clause 7. The semiconductor device of clause 6, wherein a thickness of the second protective layer in the third direction is less than or equal to a thickness of the first protective layer in the third direction, a thickness of the third protective layer in the third direction is greater than a thickness of the first protective layer in the third direction, and a thickness of the fourth protective layer in the third direction is greater than or equal to a thickness of the third protective layer in the third direction.
Clause 8. The semiconductor device of clause 6 or 7, wherein the source electrode further comprises a first source electrode on the channel layer, a second source electrode on the first source electrode, a third source electrode on the second source electrode, a fourth source electrode on the third source electrode, or a combination thereof.
Clause 9. The semiconductor device of clause 8, wherein the first source electrode is connected to the channel layer through the first protective layer, the second source electrode is located on the first source electrode and is connected to the first source electrode by penetrating the second protective layer, the third source electrode is located on the second source electrode and is connected to the second source electrode by penetrating the third protective layer, the fourth source electrode is located on the third source electrode and is connected to the third source electrode by penetrating the fourth protective layer.
Clause 10. The semiconductor device of clause 9, wherein the first source electrode is connected to the first field dispersion layer, the second source electrode is connected to the second field dispersion layer, the third source electrode is connected to the third field dispersion layer, and the fourth source electrode is connected to the source wiring layer.
Clause 11. The semiconductor device of clause 9 or 10, wherein the fourth source electrode is spaced apart from the first source electrode in the third direction, and the second protective layer, the third protective layer, the fourth protective layer, or a combination thereof is located between the fourth source electrode and the first source electrode.
Clause 12. The semiconductor device of any one of clauses 8 to 11, wherein on any cross-section perpendicular to the first direction, the first field dispersion layer is connected to the source electrode, the second field dispersion layer is spaced apart from the source electrode in the second direction, and the third field dispersion layer is spaced apart from the source electrode in the second direction, or the first field dispersion layer is spaced apart from the source electrode in the second direction, the second field dispersion layer is spaced apart from the source electrode in the second direction, and the third field dispersion layer is spaced apart from the source electrode in the second direction.
Clause 13. The semiconductor device of clause 12, wherein the semiconductor device comprises, a first via connecting the first field dispersion layer and the second field dispersion layer by penetrating the second protective layer, a second via connecting the second field dispersion layer and the third field dispersion layer by penetrating the third protective layer, a third via connecting the third field dispersion layer and the source wiring layer by penetrating the fourth protective layer, or a combination thereof.
Clause 14. The semiconductor device of clause 13, wherein a length of the first via in the second direction is shorter than a length of the second via in the second direction, and a length of the second via in the second direction is shorter than a length of the third via in the second direction, and a first angle formed by a sidewall of the first via in the second direction and a lower surface of the second protective layer is greater than a second angle formed by a sidewall of the second via in the second direction and a lower surface of the third protective layer, and a second angle formed by a sidewall of the second via in the second direction and a lower surface of the third protective layer is greater than or equal to a third angle formed by a sidewall of the third via in the second direction and a lower surface of the fourth protective layer.
Clause 15. The semiconductor device of any one of clauses 8 to 14, wherein the drain electrode comprises, a first drain electrode on the channel layer, a second drain electrode on the first drain electrode, a third drain electrode on the second drain electrode, a fourth drain electrode on the third drain electrode, or a combination thereof, wherein the first drain electrode has a first protruding portion that protrudes in the second direction toward the second protective layer and is located on the first protective layer, the second drain electrode has a second protruding portion that protrudes in the second direction toward the third protective layer and is located on the second protective layer, the third drain electrode has a third protruding portion that protrudes in the second direction toward the fourth protective layer and is located on the third protective layer, and the fourth drain electrode has a fourth protruding portion that protrudes in the second direction toward the source wiring layer and is located on the third protective layer.
Clause 16. The semiconductor device of clause 15, wherein a length of the first protruding portion in the second direction is smaller than a length of the second protruding portion in the second direction, a length of the second protruding portion in the second direction is smaller than a length of the third protruding portion in the second direction, a length of the third protruding portion in the second direction is smaller than a length of the fourth protruding portion in the second direction, and a length of the fourth protruding portion in the second direction is greater than a length of the first to third protruding portions in the second direction.
Clause 17. The semiconductor device of clause 15 or 16, wherein a thickness of the first protruding portion in the third direction is smaller than a thickness of the second protruding portion in the third direction, a thickness of the second protruding portion in the third direction is smaller than a thickness of the third protruding portion in the third direction, a thickness of the third protruding portion in the third direction is smaller than a thickness of the fourth protruding portion in the third direction, and a thickness of the fourth protruding portion in the third direction is greater than a thickness of the first to third protruding portions in the third direction.
Clause 18. The semiconductor device of any one of clauses 8 to 17, wherein the semiconductor device comprises a plurality of the gate electrode layers, and further comprises a gate connection portion extending in the second direction between the plurality of gate electrode layers and connecting the gate electrode layers, and the first source electrode has a gate contact hole passing over the gate connection portion with the first protective layer interposed therebetween, and exposing the gate connection portion, further comprises a gate draw out line located on the gate connection portion and extending in the first direction, and further comprises a gate via connecting the gate connection portion and the gate draw out line through the gate contact hole.
Clause 19. A semiconductor device, comprising, a channel layer, a barrier layer located on the channel layer and including a material having an energy band gap different from that of the channel layer, a gate electrode layer located on the barrier layer and extending in the first direction, a gate semiconductor layer between the barrier layer and the gate electrode layer, a source electrode and a drain electrode connected to the channel layer and located spaced apart from the gate electrode layer in a second direction different from the first direction, a field dispersion layer located on the gate electrode layer, connected to the source electrode, and overlapped with the gate electrode layer in a third direction different from the first direction and the second direction, and a source wiring layer located on the gate electrode layer, connected to the source electrode, and overlapped with the field dispersion layer and the third direction, wherein a length from any point of the source wiring layer overlapped with the gate electrode layer in the third direction to one end of the source wiring layer in the second direction away from the source electrode is smaller than a length from any point of the field dispersion layer overlapped with the gate electrode layer in the third direction to one end of the field dispersion layer in the second direction away from the source electrode, and a thickness of the source wiring layer in the third direction is greater than a thickness of the field dispersion layer in the third direction.
Clause 20. A semiconductor device comprising, a channel layer, a barrier layer located on the channel layer and including a material having an energy band gap different from that of the channel layer, a gate electrode layer located on the barrier layer and extending in the first direction, a gate semiconductor layer between the barrier layer and the gate electrode layer, a source electrode and a drain electrode connected to the channel layer and located spaced apart from the gate electrode layer in a second direction different from the first direction, a field dispersion layer located on the gate electrode layer, connected to the source electrode, and overlapped with the gate electrode layer in a third direction different from the first direction and the second direction, and a source wiring layer located on the field dispersion layer, connected to the source electrode, and overlapped with the gate electrode layer in the third direction, wherein one end of the source wiring layer in the second direction away from the source electrode overlaps the field dispersion layer in the third direction, and the field dispersion layer is located between one end of the source wiring layer and the barrier layer in the third direction.

## Claims

1. A semiconductor device, comprising:
a channel layer (132);
a barrier layer (136) located on the channel layer and including a material having an energy band gap different from that of the channel layer;
a gate electrode layer (155) located on the barrier layer and extending in a first direction (D1);
a gate semiconductor layer (152) between the barrier layer and the gate electrode layer;
a source electrode (173) and a drain electrode (175) connected to the channel layer, and each located spaced apart from the gate electrode layer in a second direction (D2) different from the first direction (D1);
a field dispersion layer (177) located on the gate electrode layer (155), connected to the source electrode (173), and overlapped with the gate electrode layer (155) in a third direction (D3) different from the first direction and the second direction; and
a source wiring layer (178) located on the field dispersion layer (177), connected to the source electrode (173), and overlapped with the gate electrode layer (155) in the third direction (D3),
wherein the source wiring layer (178) extends beyond a first end of the gate electrode layer (155) facing away from the source electrode (173) for a first extension length (L_178TM) in the second direction (D2), the field dispersion layer (177) extends beyond the first end of the gate electrode layer (155) for a second extension length (L_177M2), and the first extension length is less than the second extension length.

2. The semiconductor device of claim 1, wherein
the semiconductor device comprises a plurality of field dispersion layers (177) and the field dispersion layer (177M2) is an upper field dispersion layer of the plurality of field dispersion layers (177), and
the source wiring layer (178) is located on the upper field dispersion layer (177M2), which is located at an uppermost position in the third direction (D3) among the plurality of field dispersion layers (177).

3. The semiconductor device of claim 2, wherein the plurality of field dispersion layers (177) further comprises a first field dispersion layer (177M0) on the gate electrode layer (155), and a second field dispersion layer (177M1) on the first field dispersion layer, wherein the upper field dispersion layer (177M2) is on the second field dispersion layer.

4. The semiconductor device of claim 3, wherein the first field dispersion layer (177M0) extends beyond the first end of the gate electrode layer (155) for a third extension length (L_177M0) in the second direction (D2), the second field dispersion layer (177M1) extends beyond the first end of the gate electrode layer for a fourth extension length (L_177M1), the third extension length (L_177M0) is less than the fourth extension length (L_177M1), and the fourth extension length is less than the second extension length (L_177M2).

5. The semiconductor device of claim 3 or 4, wherein
a thickness of the first field dispersion layer (177M0) in the third direction (D3) is less than a thickness of the second field dispersion layer (177M1) in the third direction,
a thickness of the second field dispersion layer (177M1) in the third direction is less than a thickness of the upper field dispersion layer (177M2) in the third direction,
a thickness of the upper field dispersion layer (177M2) in the third direction is less than a thickness of the source wiring layer (178) in the third direction, and
a thickness of the source wiring layer (178) in the third direction is greater than a thickness of each of the first, second, and upper field dispersion layers in the third direction.

6. The semiconductor device of claim 3, 4, or 5, wherein the semiconductor device further comprises:
a first protective layer (156) covering the gate electrode layer (155) and located under the first field dispersion layer (177M0);
a second protective layer (140) on the first protective layer and between the first field dispersion layer (177M0) and the second field dispersion layer (177M1);
a third protective layer (150) on the second protective layer and between the second field dispersion layer (177M1) and the upper field dispersion layer (177M2); or
a fourth protective layer (160) on the third protective layer, and between the upper field dispersion layer (177M2) and the source wiring layer (178).

7. The semiconductor device of claim 6, wherein
a thickness of the second protective layer (140) in the third direction (D3) is less than or equal to a thickness of the first protective layer (156) in the third direction,
a thickness of the third protective layer (150) in the third direction is greater than a thickness of the first protective layer in the third direction, and
a thickness of the fourth protective layer (160) in the third direction is greater than or equal to a thickness of the third protective layer in the third direction.

8. The semiconductor device of claim 6 or 7, wherein
the source electrode (173) is a first source electrode (173M0) of a plurality of source electrodes,
the first source electrode (173M0) is on the channel layer (132), and
the plurality of source electrodes (173) further comprises
a second source electrode (173M1) on the first source electrode,
a third source (173M2) electrode on the second source electrode, and
a fourth source (173TM) electrode on the third source electrode.

9. The semiconductor device of claim 8, wherein
the first source electrode (173M0) is connected to the channel layer (132) through the first protective layer (156),
the second source electrode (173M1) is located on the first source electrode and penetrates the second protective layer (140) to connect to the first source electrode,
the third source electrode (173M2) is located on the second source electrode and penetrates the third protective layer (150) to connect to the second source electrode,
the fourth source electrode (173TM) is located on the third source electrode and penetrate the fourth protective layer (160) to connect to the third source electrode.

10. The semiconductor device of claim 9, wherein
the first source electrode (173M0) is connected to the first field dispersion layer (177M0),
the second source electrode (173M1) is connected to the second field dispersion layer (177M1),
the third source electrode (173M2) is connected to the upper field dispersion layer (177M2), and
the fourth source electrode (173TM) is connected to the source wiring layer (178), and
wherein
the fourth source electrode (173TM) is spaced apart from the first source electrode in the third direction (D3), and
the second protective layer (140), the third protective layer (150), and the fourth protective layer (160) are located between the fourth source electrode and the first source electrode.

11. The semiconductor device of claim 8, 9, or 10 wherein
in a cross-section perpendicular to the first direction (D1),
the first field dispersion layer (177M0) is connected to the plurality of source electrodes (173), the second field dispersion layer (177M1) is spaced apart from the plurality of source electrodes in the second direction (D2), and the upper field dispersion layer (177M2) is spaced apart from the plurality of source electrodes (177) in the second direction, or
the first field dispersion layer (177M0) is spaced apart from the plurality of source electrodes (177) in the second direction (D2), the second field dispersion layer (177M1) is spaced apart from the plurality of source electrodes in the second direction, and the upper field dispersion layer (177M2) is spaced apart from the plurality of source electrodes (177) in the second direction, and
wherein the semiconductor device comprises
a first via (179V0) penetrating the second protective layer (140) and connecting the first field dispersion layer (177M0) and the second field dispersion layer (177M1),
a second via (179V1) penetrating the third protective layer (150) and connecting the second field dispersion layer (177M1) and the upper field dispersion layer (177M2), and
a third via (179V2) penetrating the third protective layer (150) and connecting the upper field dispersion layer (177M2) and the source wiring layer (178), and
wherein
a length of the first via (179V0) in the second direction (D2) is shorter than a length of the second via (179V1) in the second direction, and a length of the second via (179V1) in the second direction is shorter than a length of the third via (179V2) in the second direction, and
a first angle formed by a sidewall of the first via (179V0) in the second direction (D2) and a lower surface of the second protective layer (140) is greater than a second angle formed by a sidewall of the second via (179V1) in the second direction and a lower surface of the third protective layer (150), and a second angle formed by a sidewall of the second via (179V1) in the second direction (D2) and a lower surface of the third protective layer (150) is greater than or equal to a third angle formed by a sidewall of the third via (179V2) in the second direction and a lower surface of the fourth protective layer (160).

12. The semiconductor device of any one of claims 8 to 11, further comprising a plurality of drain electrodes (175), wherein
the drain electrode is a first drain (175M0) electrode of the plurality of drain electrodes and is on the channel layer (132), and
the plurality of drain electrodes further comprises
a second drain electrode (175M1) on the first drain electrode,
a third drain electrode (175M2) on the second drain electrode, and
a fourth drain electrode (175TM) on the third drain electrode,
wherein the first drain electrode (175M0) has a first protruding portion (175M0_p) that protrudes in the second direction (D2) toward the second protective layer (140) and is located on the first protective layer (156) ,
the second drain electrode (175M1) has a second protruding portion (175M1_p) that protrudes in the second direction toward the third protective layer (150) and is located on the second protective layer (140),
the third drain electrode (175M2) has a third protruding portion (175M2_p) that protrudes in the second direction (D2) toward the fourth protective layer (160) and is located on the third protective layer (150), and
the fourth drain electrode (175TM) has a fourth protruding portion (175TM_p) that protrudes in the second direction toward the source wiring layer (178) and is located on the third protective layer (150).

13. The semiconductor device of claim 12, wherein
a length of the first protruding portion (175M0_p) in the second direction (D2) is less than a length of the second protruding portion (175M1_p) in the second direction,
a length of the second protruding portion in the second direction is less than a length of the third protruding portion (175M2_p) in the second direction,
a length of the third protruding portion (175M2_p) in the second direction is less than a length of the fourth protruding portion (175TM_p) in the second direction, and
a length of the fourth protruding portion in the second direction is less than a length of each of the first to third protruding portions in the second direction, and
wherein
a thickness of the first protruding portion (175M0_p) in the third direction (D3) is less than a thickness of the second protruding portion (175M 1_p) in the third direction,
a thickness of the second protruding portion (175M1_p) in the third direction is less than a thickness of the third protruding portion (175M2_p) in the third direction,
a thickness of the third protruding portion (175M2_p) in the third direction is less than a thickness of the fourth protruding portion (175M3_p) in the third direction, and
a thickness of the fourth protruding portion (175TM_p) in the third direction is greater than a thickness of each of the first to third protruding portions in the third direction, and
wherein
the gate electrode layer (155) is a first gate electrode layer and the semiconductor device further comprises a second gate electrode layer and a third gate electrode layer, and
the first gate electrode layer (155) comprises a gate connection portion (155c) extending in the second direction (D2) between a first portion of the first gate electrode layer and a second portion of the first gate electrode layer,
the second gate electrode layer comprises a gate draw out line (193M1) located above the gate connection portion (155c) and extending in the first direction (D1), and
the third gate electrode layer comprises a gate via (179VG) connecting the gate connection portion (155c) and the gate draw out line (193M1) through a gate contact hole (CH1) formed in the first source electrode (177M0) over the gate connection portion (155c) with the first protective layer (156) interposed between the gate via and the first source electrode in the gate contact hole (CH1).

14. The semiconductor device of any one of claims 1 to 13,
wherein the source wiring layer (178) extends beyond a first end of the gate electrode layer (155) facing away from the source electrode (173) by a first extension length (L_178TM) in the second direction (D2), the field dispersion layer (177) extends beyond the first end of the gate electrode layer (155) for a second extension length (L_177M2), and the first extension length is less than the second extension length, and
a thickness of the source wiring layer (178) in the third direction is greater than a thickness of the field dispersion layer (177) in the third direction (D3).

15. The semiconductor device of any one of claims 1 to 14,
wherein an end of the source wiring layer (178) in the second direction (D2) extending away from the source electrode (173) overlaps the field dispersion layer (177) in the third direction (D3),
the field dispersion layer (177) is located between the source wiring layer (178) and the barrier layer (136) in the third direction, and
an end of the field dispersion layer (177) in the second direction (D2) is between the end of the source electrode (173) and an end of the barrier layer (136) facing the drain electrode (175) in the second direction.
